# EUROPEAN PATENT APPLICATION

(11) **EP 4 657 419 A1**
(43) Date of publication of application: **03.12.2025**
(21) Application number: 25179291.7
(22) Date of filing: 28.05.2025
(51) Int. Cl.: G09G 3/20, G09G 3/3233

(54) **PIXEL CIRCUIT AND ELECTRONIC APPARATUS INCLUDING THE SAME**

(30) Priority: 29.05.2024 KR 20240070231
(71) Applicant: Samsung Display Co., Ltd., Yongin-si, Gyeonggi-do 17113 (KR)
(72) Inventor: Kim, Kwihyun, Yongin-si, Gyeonggi-do (KR); Kim, Dongwoo, Yongin-si, Gyeonggi-do (KR); Lee, Sehyun, Yongin-si, Gyeonggi-do (KR); Chang, Haksun, Yongin-si, Gyeonggi-do (KR)
(74) Representative: Gulde & Partner

(57) **Abstract**

A pixel circuit includes a first transistor, a second transistor, a third transistor, a seventh transistor, a ninth transistor and a light emitting element. The first transistor includes a control electrode connected to a first node, a first electrode connected to a second node and a second electrode connected to a third node. The second transistor is connected to the first node and the second node. The third transistor is configured to apply a data voltage to the first transistor. The seventh transistor is connected to a fourth node and configured to apply a driving current to the light emitting element. The ninth transistor is configured to apply a constant-current voltage to the fourth node. The light emitting element is configured to emit a light based on the data voltage and the constant-current voltage. The first transistor is an N-type transistor. The seventh transistor is a P-type transistor.

## Description

### BACKGROUND

### 1. Field

Embodiments of the present invention relate to a pixel circuit and an electronic apparatus including the pixel circuit. More particularly, embodiments of the present invention relate to a pixel circuit driven in a pulse width modulation method, operating an internal compensation of a threshold voltage, including fewer transistors, and thus, applicable to a ultra-high resolution display apparatus and an electronic apparatus including the pixel circuit.

### 2. Description of the Related Art

Generally, a display apparatus includes a display panel and a display panel driver. The display panel includes a plurality of gate lines, a plurality of data lines and a plurality of pixels. The display panel driver includes a gate driver, a data driver and a driving controller. The gate driver outputs gate signals to the gate lines. The data driver outputs data voltages to the data lines. The driving controller controls the gate driver and the data driver.

A conventional pixel circuit driven in a pulse width modulation method and operating internal compensation of the threshold voltage may include nineteen or more transistors and three or more capacitors. When the pixel circuit includes nineteen or more transistors and three or more capacitors, the pixel circuit may not be applied to an ultra-high resolution display apparatus due to a limitation in integration.

In addition, a driving transistor of a pulse width modulation circuit of the conventional pixel circuit is a P-type transistor so that an afterimage characteristic, a response time characteristic when changing from a black image to a white image and a luminance changing rate characteristic according to a temperature may be deteriorated.

### SUMMARY

Embodiments of the present invention provide a pixel circuit driven in a pulse width modulation method, operating an internal compensation of a threshold voltage, including fewer transistors, and thus, being applicable to an ultra-high resolution display apparatus.

Embodiments of the present invention also provide an electronic apparatus including the pixel circuit.

In an embodiment of a pixel circuit according to the present invention, the pixel circuit includes a first transistor, a second transistor, a third transistor, a seventh transistor, a ninth transistor and a light emitting element. The first transistor includes a control electrode connected to a first node, a first electrode connected to a second node and a second electrode connected to a third node. The second transistor is connected to the first node and the second node. The third transistor is configured to apply a data voltage to the first transistor. The seventh transistor is connected to a fourth node and configured to apply a driving current to the light emitting element. The ninth transistor is configured to apply a constant-current voltage to the fourth node. The light emitting element is configured to emit a light based on the data voltage and the constant-current voltage. The first transistor is an N-type transistor. The seventh transistor is a P-type transistor.

In an embodiment, the second transistor, the third transistor and the ninth transistor may be N-type transistors.

In an embodiment, the pixel circuit may further include a sixth transistor including a control electrode configured to receive a first initialization signal, a first electrode connected to the first node and a second electrode connected to a first initialization voltage terminal.

In an embodiment, the pixel circuit may further include a first capacitor including a first electrode configured to receive a sweep signal and a second electrode connected to the first node.

In an embodiment, the pixel circuit may further include a fourth transistor including a control electrode configured to receive a first emission signal, a first electrode configured to receive a first power voltage and a second electrode connected to the second node and a fifth transistor including a control electrode configured to receive a second emission signal, a first electrode connected to the third node and a second electrode connected to the fourth node.

In an embodiment, the pixel circuit may further include an eighth transistor including a control electrode configured to receive a first emission signal, a first electrode configured to receive a second power voltage and a second electrode connected to a first electrode of the seventh transistor.

In an embodiment, the pixel circuit may further include an eighth transistor including a control electrode configured to receive a first emission signal, a first electrode connected to a second electrode of the seventh transistor and a second electrode connected to an anode electrode of the light emitting element.

In an embodiment, the pixel circuit may further include a tenth transistor including a control electrode configured to receive a second initialization signal, a first electrode connected to an anode electrode of the light emitting element and a second electrode configured to receive a second initialization voltage.

In an embodiment, the pixel circuit may further include a second capacitor including a first electrode configured to receive a second power voltage and a second electrode connected to the fourth node.

In an embodiment, when the first transistor is turned off and the seventh transistor is turned on in a light emission period, the light emitting element may be configured to emit a light. When the first transistor is turned on in a light emission off period, the seventh transistor may be turned off and the light emitting element may be configured to stop emitting a light.

In an embodiment, the pixel circuit may further include a fourth transistor including a control electrode configured to receive a first emission signal, a first electrode configured to receive a first power voltage and a second electrode connected to the second node and an eighth transistor including a control electrode configured to receive the first emission signal, a first electrode configured to receive a second power voltage and a second electrode connected to a first electrode of the seventh transistor. The first power voltage may be greater than the second power voltage.

In an embodiment, the pixel circuit may further include a tenth transistor including a control electrode configured to receive a second initialization signal, a first electrode connected to an anode electrode of the light emitting element and a second electrode configured to receive a second initialization voltage. A third power voltage may be applied to a cathode electrode of the light emitting element. The second initialization voltage may be less than the third power voltage.

In an embodiment, the first transistor may further include a second control electrode connected to the third node.

In an embodiment, the first transistor may further include a second control electrode connected to the first node.

In an embodiment, the second transistor may include a control electrode configured to receive a first scan signal, a first electrode connected to the first node and a second electrode connected to the second node. The third transistor may include a control electrode configured to receive the first scan signal, a first electrode configured to receive the data voltage and a second electrode connected to the third node. The seventh transistor may include a control electrode connected to the fourth node, a first electrode connected to a fifth node and a second electrode connected to an anode electrode of the light emitting element. The ninth transistor may include a control electrode configured to receive a second scan signal, a first electrode connected to the fourth node and a second electrode connected to a first initialization voltage terminal. The light emitting element may include the anode electrode and a cathode electrode configured to receive a third power voltage.

In an embodiment, the pixel circuit may further include a fourth transistor including a control electrode configured to receive a first emission signal, a first electrode configured to receive a first power voltage and a second electrode connected to the second node, a fifth transistor including a control electrode configured to receive a second emission signal, a first electrode connected to the third node and a second electrode connected to the fourth node, a sixth transistor including a control electrode configured to receive a first initialization signal, a first electrode connected to the first node and a second electrode connected to the first initialization voltage terminal, an eighth transistor including a control electrode configured to receive the first emission signal, a first electrode configured to receive a second power voltage and a second electrode connected to the fifth node, a tenth transistor including a control electrode configured to receive a second initialization signal, a first electrode connected to the anode electrode of the light emitting element and a second electrode configured to receive a second initialization voltage, a first capacitor including a first electrode configured to receive a sweep signal and a second electrode connected to the first node and a second capacitor including a first electrode configured to receive the second power voltage and a second electrode connected to the fourth node.

In an embodiment, the second transistor, the third transistor, the sixth transistor and the ninth transistor may be N-type transistors. The fourth transistor, the fifth transistor, the eighth transistor and the tenth transistor may be P-type transistors.

In an embodiment, the first initialization signal may have an active level in a first period. The second initialization signal may have an active level in the first period. The first scan signal may have an inactive level in the first period. The second scan signal may have an inactive level in the first period. The first emission signal may have an inactive level in the first period. The second emission signal may have an inactive level in the first period. The sweep signal may have a low level in the first period. A voltage outputted from the first initialization voltage terminal may have a first level in the first period.

In an embodiment, the first initialization signal may have an inactive level in a second period. The second initialization signal may have an active level in the second period. The first scan signal may have an active pulse in the second period. The second scan signal may have an inactive level in the second period. The first emission signal may have an inactive level in the second period. The second emission signal may have an inactive level in the second period. The sweep signal may have a low level in the second period.

In an embodiment, the first initialization signal may have an inactive level in a third period. The second initialization signal may have an active level in the third period. The first scan signal may have an inactive level in the third period. The second scan signal may have an active level in the third period. The first emission signal may have an inactive level in the third period. The second emission signal may have an active level in the third period. The sweep signal may have a low level in the third period. A voltage outputted from the first initialization voltage terminal may have a second level in the third period.

In an embodiment, the first initialization signal may have an inactive level in a fourth period and a fifth period. The second initialization signal may have an inactive level in the fourth period and the fifth period. The first scan signal may have an inactive level in the fourth period and the fifth period. The second scan signal may have an inactive level in the fourth period and the fifth period. The first emission signal may have an active level in the fourth period and the fifth period. The second emission signal may have an active level in the fourth period and the fifth period. The sweep signal is configured to gradually increase from a low level in the fourth period and the fifth period.

In an embodiment, the first initialization signal may have an active level in a first initialization period. The second initialization signal may have an active level in the first initialization period. The first scan signal may have an inactive level in the first initialization period. The second scan signal may have an inactive level in the first initialization period. The first emission signal may have an inactive level in the first initialization period. The second emission signal may have an inactive level in the first initialization period. The sweep signal may have a low level in the first initialization period. A voltage outputted from the first initialization voltage terminal may have a first level in the first initialization period. The first initialization signal may have an inactive level in a second initialization period subsequent to the first initialization period. The second initialization signal may have the active level in the second initialization period. The first scan signal may have the inactive level in the second initialization period. The second scan signal may have an active level in the second initialization period. The first emission signal may have the inactive level in the second initialization period. The second emission signal may have the inactive level in the second initialization period. The sweep signal may have the low level in the second initialization period. The voltage outputted from the first initialization voltage terminal may have the first level in the second initialization period.

In an embodiment, the first initialization signal may have an active level in a first period of a writing frame in which the data voltage is applied to the first transistor and the light emitting element emits a light. The first scan signal may have an active pulse in a second period of the writing frame. The first initialization signal may have an inactive level in a first period of a holding frame in which the data voltage is not applied to the first transistor and the light emitting element emits a light. The first scan signal may have an inactive level in a second period of the holding frame.

In an embodiment, the first initialization signal, the second initialization signal, the first scan signal, the second scan signal, the first emission signal, the second emission signal and the sweep signal may be sequentially applied to pixel rows.

In an embodiment, the pixel circuit may further include a third capacitor including a first electrode connected to an control electrode of the seventh transistor and a second electrode connected to a second electrode of the seventh transistor.

In an embodiment of an electronic apparatus according to the present invention, the electronic apparatus includes a display panel, a gate driver and a data driver. The display panel includes a pixel circuit. The gate driver is configured to output a gate signal to the pixel circuit. The data driver is configured to output a data voltage to the pixel circuit. The pixel circuit includes a first transistor, a second transistor, a third transistor, a seventh transistor, a ninth transistor and a light emitting element. The first transistor includes a control electrode connected to a first node, a first electrode connected to a second node and a second electrode connected to a third node. The second transistor is connected to the first node and the second node. The third transistor is configured to apply the data voltage to the first transistor. The seventh transistor is connected to a fourth node and configured to apply a driving current to the light emitting element. The ninth transistor is configured to apply a constant-current voltage to the fourth node. The light emitting element is configured to emit a light based on the data voltage and the constant-current voltage. The first transistor is an N-type transistor. The seventh transistor is a P-type transistor.

According to the pixel circuit and the electronic apparatus including the pixel circuit, the pixel circuit may include ten transistors and two capacitors. The pixel circuit may be driven in the pulse width modulation method, operate the internal compensation of the threshold voltage and include the relatively fewer transistors compared to the conventional pixel circuit, so that the high integration may be achieved. Thus, the pixel circuit may be applicable to an ultra-high resolution display apparatus.

In addition, the driving transistor of the pulse width modulation circuit is an N-type transistor so that an afterimage characteristic, a response time characteristic when changing from a black image to a white image and a luminance changing rate characteristic according to a temperature may be effectively enhanced.

In addition, the driving transistor of the constant current generating circuit is a P-type transistor so that a mobility may be effectively enhanced.

In addition, the second initialization voltage applied to the second electrode of the tenth transistor is less than the third power voltage applied to the cathode electrode of the light emitting element so that a black characteristic of the pixel circuit may be effectively enhanced.

In addition, the first initialization voltage applied to the control electrode of the first transistor and a constant-current voltage applied to the control electrode of the seventh transistor are outputted from the same voltage terminal so that a number of transistors and a number of signal lines may be effectively reduced.

### BRIEF DESCRIPTION OF THE DRAWINGS

The above and other features and advantages of the invention will become more apparent by describing in detailed embodiments thereof with reference to the accompanying drawings, in which:
FIG. 1 is a block diagram illustrating a display apparatus according to an embodiment of the present invention;
FIG. 2 is a circuit diagram illustrating a pixel circuit of the display panel of FIG. 1;
FIG. 3 is a circuit diagram illustrating an operation of the pixel circuit of FIG. 2 in a first period of a driving timing;
FIG. 4 is a timing diagram illustrating an example of input signals applied to the pixel circuit of FIG. 2 and node signals of the pixel circuit of FIG. 2 in the first period;
FIG. 5 is a circuit diagram illustrating an operation of the pixel circuit of FIG. 2 in a second period of the driving timing;
FIG. 6 is a timing diagram illustrating an example of input signals applied to the pixel circuit of FIG. 2 and node signals of the pixel circuit of FIG. 2 in the second period;
FIG. 7 is a circuit diagram illustrating an operation of the pixel circuit of FIG. 2 in a third period of the driving timing;
FIG. 8 is a timing diagram illustrating an example of input signals applied to the pixel circuit of FIG. 2 and node signals of the pixel circuit of FIG. 2 in the third period;
FIG. 9 is a circuit diagram illustrating an operation of the pixel circuit of FIG. 2 in a fourth period of the driving timing;
FIG. 10 is a timing diagram illustrating an example of input signals applied to the pixel circuit of FIG. 2 and node signals of the pixel circuit of FIG. 2 in the fourth period;
FIG. 11 is a circuit diagram illustrating an operation of the pixel circuit of FIG. 2 in a fifth period of the driving timing;
FIG. 12 is a timing diagram illustrating an example of input signals applied to the pixel circuit of FIG. 2 and node signals of the pixel circuit of FIG. 2 in the fifth period;
FIG. 13 is a circuit diagram illustrating an operation of the pixel circuit of FIG. 2 in a second initialization period of the driving timing;
FIG. 14 is a timing diagram illustrating an example of input signals applied to the pixel circuit of FIG. 2 and node signals of the pixel circuit of FIG. 2 in the second initialization period;
FIG. 15 is a diagram illustrating a driving frequency of the display panel of FIG. 1;
FIG. 16 is a timing diagram illustrating an example of input signals applied to the pixel circuit of FIG. 2 and node signals of the pixel circuit of FIG. 2 in a writing frame;
FIG. 17 is a timing diagram illustrating an example of input signals applied to the pixel circuit of FIG. 2 and node signals of the pixel circuit of FIG. 2 in a holding frame;
FIG. 18 is a timing diagram illustrating an example of input signals applied to the pixel circuit of FIG. 2 and node signals of the pixel circuit of FIG. 2;
FIG. 19 is a circuit diagram illustrating a pixel circuit of a display panel of a display apparatus according to an embodiment of the present invention;
FIG. 20 is a circuit diagram illustrating a pixel circuit of a display panel of a display apparatus according to an embodiment of the present invention;
FIG. 21 is a circuit diagram illustrating a pixel circuit of a display panel of a display apparatus according to an embodiment of the present invention;
FIG. 22 is a circuit diagram illustrating a pixel circuit of a display panel of a display apparatus according to an embodiment of the present invention;
FIG. 23 is a circuit diagram illustrating a pixel circuit of a display panel of a display apparatus according to an embodiment of the present invention;
FIG. 24 is a block diagram illustrating an electronic apparatus according to an embodiment of the present invention;
FIG. 25 is a diagram illustrating an example in which the electronic apparatus of FIG. 24 is implemented as a smart phone; and
FIG. 26 is a diagram illustrating an example in which the electronic apparatus of FIG. 24 is implemented as a smart watch.

### DETAILED DESCRIPTIONINVENTION

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Hereinafter, the present invention will be explained in detail with reference to the accompanying drawings.

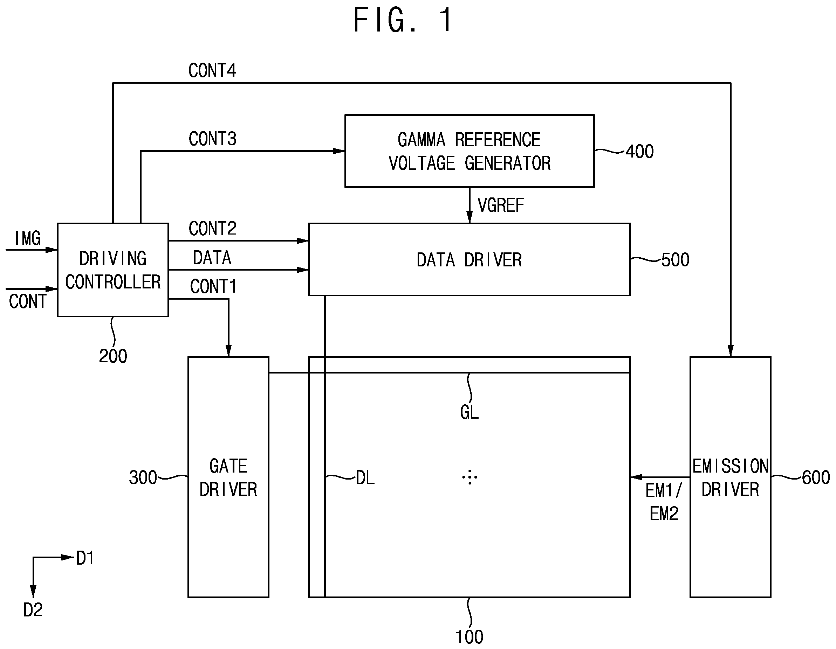

FIG. 1 is a block diagram illustrating a display apparatus according to an embodiment of the present invention.

Referring to FIG. 1, the display apparatus includes a display panel 100 and a display panel driver. The display panel driver includes a driving controller 200, a gate driver 300, a gamma reference voltage generator 400 and a data driver 500. The display panel driver may further include an emission driver 600.

The display panel 100 has a display region on which an image is displayed and a peripheral region adjacent to the display region.

The display panel 100 includes a plurality of gate lines GL, a plurality of data lines DL and a plurality of pixels electrically connected to the gate lines GL and the data lines DL. The gate lines GL may extend in a first direction D1 and the data lines DL may extend in a second direction D2 crossing the first direction D1.

The driving controller 200 receives input image data IMG and an input control signal CONT from an external apparatus. For example, the input image data IMG may include red image data, green image data and blue image data. The input image data IMG may include white image data. The input image data IMG may include magenta image data, cyan image data and yellow image data. The input control signal CONT may include a master clock signal and a data enable signal. The input control signal CONT may further include a vertical synchronizing signal and a horizontal synchronizing signal.

The driving controller 200 generates a first control signal CONT1, a second control signal CONT2, a third control signal CONT3, a fourth control signal CONT4 and a data signal DATA based on the input image data IMG and the input control signal CONT.

The driving controller 200 generates the first control signal CONT1 for controlling an operation of the gate driver 300 based on the input control signal CONT, and outputs the first control signal CONT1 to the gate driver 300. The first control signal CONT1 may include a vertical start signal and a gate clock signal.

The driving controller 200 generates the second control signal CONT2 for controlling an operation of the data driver 500 based on the input control signal CONT, and outputs the second control signal CONT2 to the data driver 500. The second control signal CONT2 may include a horizontal start signal and a load signal.

The driving controller 200 generates the data signal DATA based on the input image data IMG. The driving controller 200 outputs the data signal DATA to the data driver 500.

The driving controller 200 generates the third control signal CONT3 for controlling an operation of the gamma reference voltage generator 400 based on the input control signal CONT, and outputs the third control signal CONT3 to the gamma reference voltage generator 400.

The driving controller 200 generates the fourth control signal CONT4 for controlling an operation of the emission driver 600 based on the input control signal CONT, and outputs the fourth control signal CONT4 to the emission driver 600.

The gate driver 300 generates gate signals driving the gate lines GL in response to the first control signal CONT1 received from the driving controller 200. The gate driver 300 may output the gate signals to the gate lines GL.

In an embodiment of the present invention, the gate driver 300 may be integrated on the peripheral region of the display panel 100. In an embodiment of the present invention, the gate driver 300 may be mounted on the peripheral region of the display panel 100.

The gamma reference voltage generator 400 generates a gamma reference voltage VGREF in response to the third control signal CONT3 received from the driving controller 200. The gamma reference voltage generator 400 provides the gamma reference voltage VGREF to the data driver 500. The gamma reference voltage VGREF has a value corresponding to a level of the data signal DATA.

In an embodiment, the gamma reference voltage generator 400 may be disposed in the driving controller 200, or in the data driver 500.

The data driver 500 receives the second control signal CONT2 and the data signal DATA from the driving controller 200, and receives the gamma reference voltages VGREF from the gamma reference voltage generator 400. The data driver 500 converts the data signal DATA into data voltages having an analog type using the gamma reference voltages VGREF. The data driver 500 outputs the data voltages to the data lines DL.

In an embodiment of the present invention, the data driver 500 may be integrated on the peripheral region of the display panel 100. In an embodiment of the present invention, the data driver 500 may be mounted on the peripheral region of the display panel 100.

The emission driver 600 generates emission signals EM1 and EM2 in response to the fourth control signal CONT4 received from the driving controller 200. The emission driver 600 may output the emission signals EM1 and EM2 to the display panel 100.

In an embodiment of the present invention, the emission driver 600 may be integrated on the peripheral region of the display panel 100. In an embodiment of the present invention, the emission driver 600 may be mounted on the peripheral region of the display panel 100.

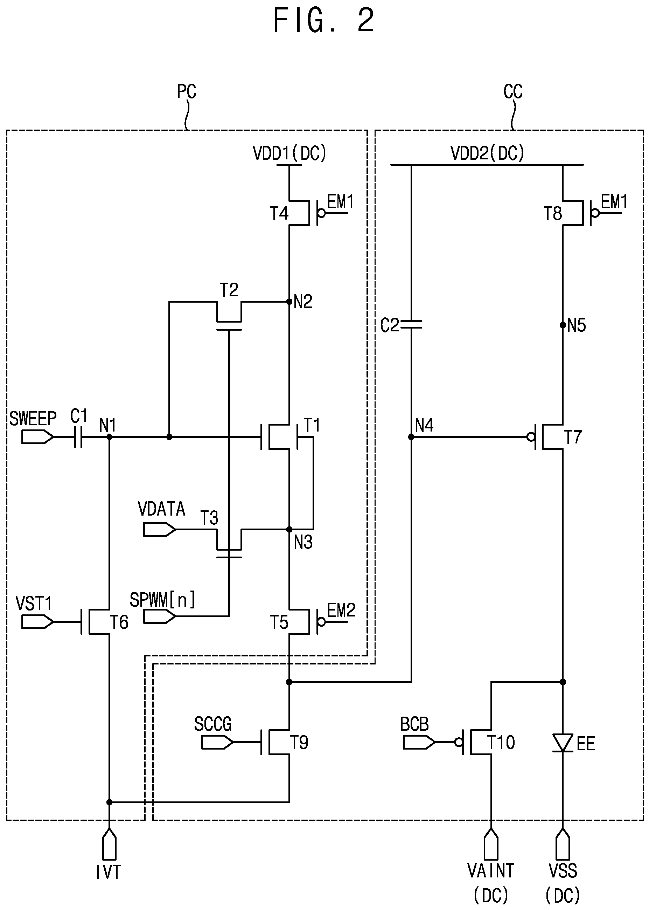

FIG. 2 is a circuit diagram illustrating a pixel circuit of the display panel 100 of FIG. 1.

Referring to FIGS. 1 and 2, the pixel circuit may include a first circuit PC and a second circuit CC.

The first circuit PC may be a "pulse width modulation circuit" for a pulse width modulation ("PWM"). The second circuit CC may be a "constant current generation circuit" for a constant current generation ("CCG").

The first circuit PC may include first to sixth transistors T1, T2, T3, T4, T5 and T6 and a first capacitor C1. The second circuit CC may include seventh to tenth transistors T7, T8, T9 and T10 and a second capacitor C2. The second circuit CC may include a light emitting element EE.

For example, the light emitting element EE may be a light emitting diode. In an embodiment, the light emitting element EE may be a micro light emitting diode. However, the light emitting element EE is not limited thereto.

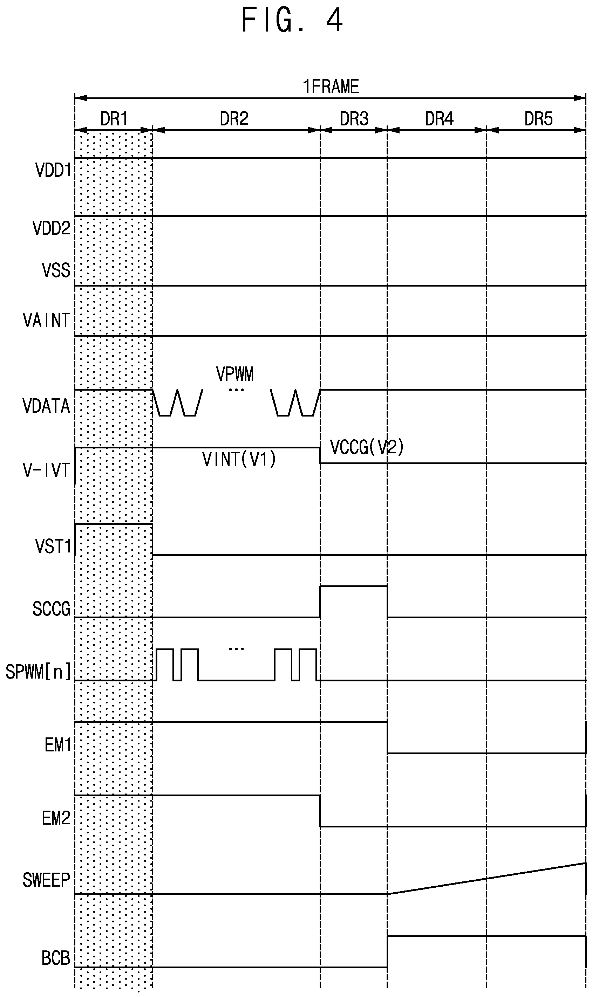

The pixel circuit includes the first transistor T1, the second transistor T2, the third transistor T3, the seventh transistor T7, the ninth transistor T9 and the light emitting element EE. The first transistor T1 includes a control electrode connected to a first node N1, a first electrode connected to a second node N2 and a second electrode connected to a third node N3. The second transistor T2 is connected to the first node N1 and the second node N2. The third transistor T3 applies a data voltage (VPWM of FIG. 4) to the first transistor T1. The seventh transistor T7 is connected to a fourth node N4 and applies a driving current to the light emitting element EE. The ninth transistor T9 applies a constant-current voltage (VCCG of FIG. 4) to the fourth node N4. The light emitting element EE emits a light based on the data voltage (VPWM of FIG. 4) and the constant-current voltage (VCCG of FIG. 4).

The first transistor T1 is an N-type transistor. The seventh transistor T7 is a P-type transistor.

The second transistor T2 may include a control electrode for receiving a first scan signal SPWM[n], a first electrode connected to the first node N1 and a second electrode connected to the second node N2.

The third transistor T3 may include a control electrode for receiving the first scan signal SPWM[n], a first electrode for receiving the data voltage VDATA and a second electrode connected to the third node N3.

The seventh transistor T7 may include a control electrode connected to the fourth node N4, a first electrode connected to a fifth node N5 and a second electrode connected to an anode electrode of the light emitting element EE.

The ninth transistor T9 may include a control electrode for receiving a second scan signal SCCG, a first electrode connected to the fourth node N4 and a second electrode connected to a first initialization voltage terminal IVT, which supplies a voltage V-IVT.

The light emitting element EE may include the anode electrode and a cathode electrode. The cathode electrode may receive a third power voltage VSS.

The fourth transistor T4 may include a control electrode for receiving a first emission signal EM1, a first electrode for receiving a first power voltage VDD1 and a second electrode connected to the second node N2.

The fifth transistor T5 may include a control electrode for receiving a second emission signal EM2, a first electrode connected to the third node N3 and a second electrode connected to the fourth node N4.

The sixth transistor T6 may include a control electrode for receiving a first initialization signal VST1, a first electrode connected to the first node N1 and a second electrode connected to the first initialization voltage terminal IVT, which supplies the voltage V-IVT.

The eighth transistor T8 may include a control electrode for receiving the first emission signal EM1, a first electrode for receiving a second power voltage VDD2 and a second electrode connected to the fifth node N5.

The tenth transistor T10 may include a control electrode for receiving a second initialization signal BCB, a first electrode connected to the anode electrode of the light emitting element EE and a second electrode for receiving a second initialization voltage VAINT.

The first capacitor C1 may include a first electrode for receiving a sweep signal SWEEP and a second electrode connected to the first node N1.

The second capacitor C2 may include a first electrode for receiving the second power voltage VDD2 and a second electrode connected to the fourth node N4.

As explained above, the pixel circuit may include ten transistors and two capacitors.

For example, the second transistor T2, the third transistor T3, the sixth transistor T6 and the ninth transistor T9 may be N-type transistors. The fourth transistor T4, the fifth transistor T5, the eighth transistor T8 and the tenth transistor T10 may be P-type transistors.

In the present embodiment, some of the transistors in the pixel circuit may be P-type transistors and some of the transistors in the pixel circuit may be N-type transistors. For example, the P-type transistor may be a low temperature polycrystalline silicon ("LTPS") transistor. For example, the N-type transistor may be an oxide semiconductor transistor.

In the present embodiment, the first transistor T1 may further include a second control electrode connected to the third node N3. When the second control electrode of the first transistor T1 is connected to the third node N3, a threshold voltage of the first transistor T1 may be shifted in a positive direction so that a reliability of an operation of the first transistor T1 may be enhanced.

In the present embodiment, a first initialization voltage VINT applied to the control electrode of the first transistor T1 and a constant-current voltage (VCCG of FIG. 4) applied to the control electrode of the seventh transistor T7 are outputted from the same voltage terminal IVT which is connected to the second electrodes of the sixth transistor T6 and the ninth transistor T9 so that a number of the transistors and a number of the signal lines may be reduced.

The data voltage (VPWM of FIG. 4) may have same or different voltage levels depending on intensities of light emission of pixels. In contrast, the constant-current voltage (VCCG of FIG. 4) may have the same voltage level for all pixels. Alternatively, the constant-current voltage (VCCG of FIG. 4) may have a first voltage level for red pixels, a second voltage level different from the first voltage level for green pixels and a third voltage level different from the first voltage level and the second voltage level for blue pixels.

For example, the first power voltage VDD1 and the second power voltage VDD2 may be high power voltages for determining a light emission degree of the light emitting element EE and the third power voltage VSS may be a low power voltage for determining the light emission degree of the light emitting element EE. The first power voltage VDD1 and the second power voltage VDD2 may each be greater than the third power voltage VSS.

In addition, the first power voltage VDD1 may be greater than the second power voltage VDD2.

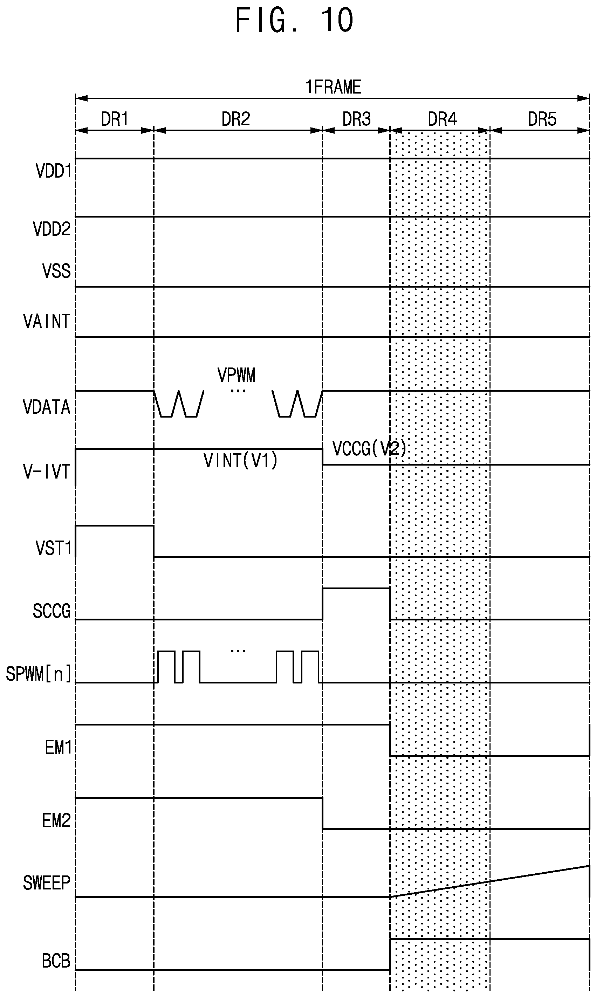

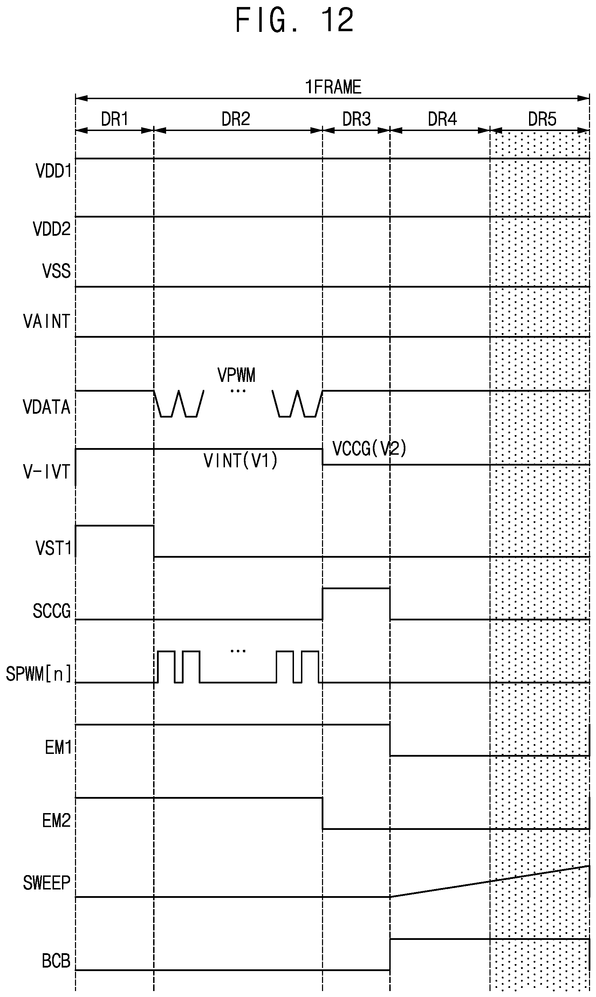

When the first transistor T1 is turned off and the seventh transistor T7 is turned on in a light emission period (DR4 in FIG. 10), the light emitting element EE may emit a light. When the first transistor T1 is turned on, and accordingly, the first power voltage VDD1 is applied to the control electrode of the seventh transistor T7 in a light emission off period (DR5 in FIG 12), the seventh transistor T7 may be turned off and the light emitting element EE may stop emitting a light.

Herein, if the first power voltage VDD1 is greater than the second power voltage VDD2, the seventh transistor T7 may be maintained in a turned-off state more reliably when the first power voltage VDD1 is applied to the control electrode of the seventh transistor T7.

For example, the second initialization voltage VAINT may be less than the third power voltage VSS. When the second initialization voltage VAINT is less than the third power voltage VSS, a leakage current may be prevented from flowing through the light emitting element EE. Thus, a black characteristic of the pixel circuit may be enhanced.

In the present embodiment, the first scan signal SPWM[n] may be a progressive scan signal having different timings for pixel rows. Herein, [n] may represent an n-th pixel row. The pixel circuit of FIG. 2 for receiving the first scan signal SPWM[n] may be a pixel circuit included in the n-th pixel row.

The first initialization signal VST1, the second initialization signal BCB and the second scan signal SCCG may be global scan signals having the same timing regardless of the pixel row. In addition, the first emission signal EM1 and the second emission signal EM2 may be global scan signals having the same timing regardless of the pixel row.

The first power voltage VDD1, the second power voltage VDD2, the third power voltage VSS and the second initialization voltage VAINT may be direct-current voltages. In contrast, the voltage V-IVT outputted from the first initialization voltage terminal IVT may be an alternating voltage. For example, the voltage V-IVT outputted from the first initialization voltage terminal IVT may have a first level V1 and a second level V2. The first level V1 may be the first initialization voltage VINT applied to the control electrode of the first transistor T1. The second level V2 may be the constant-current voltage (VCCG of FIG. 4) applied to the control electrode of the seventh transistor T7.

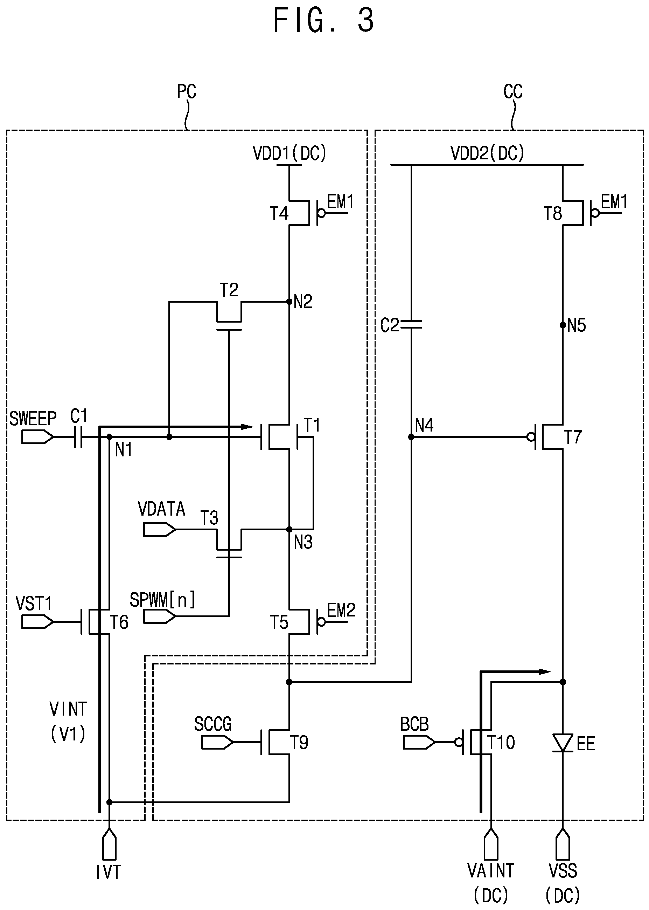

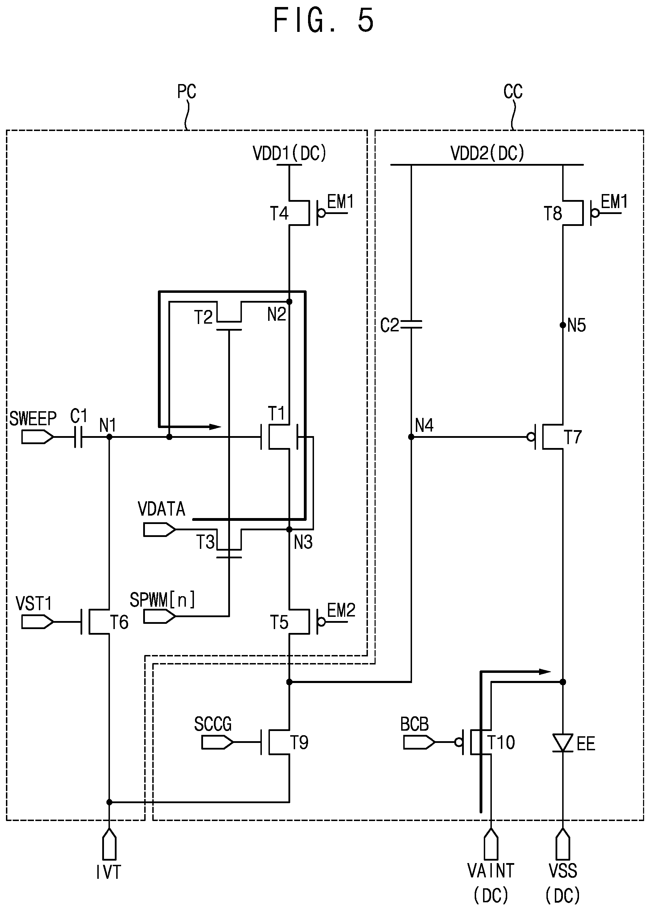

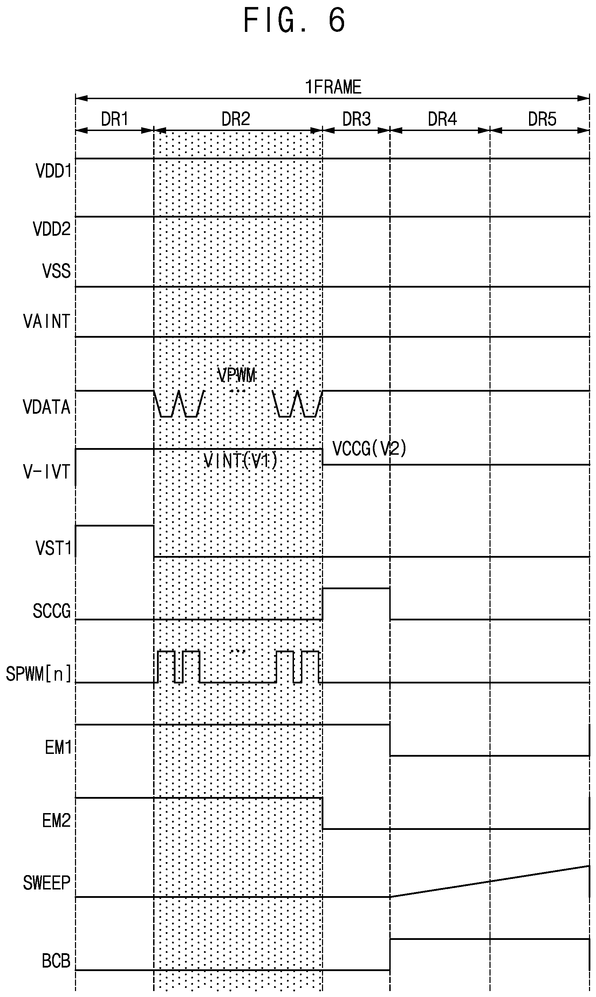

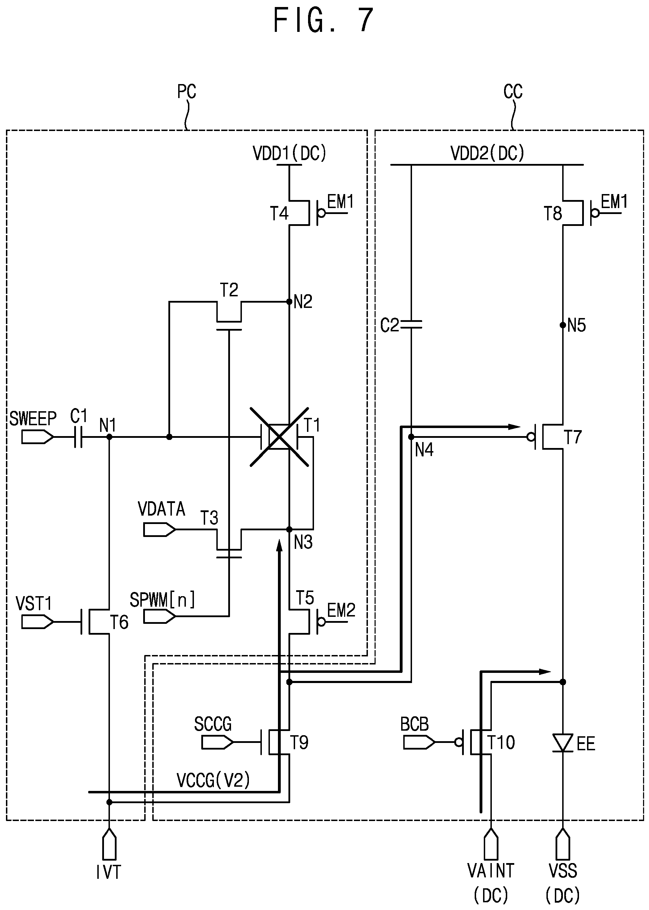

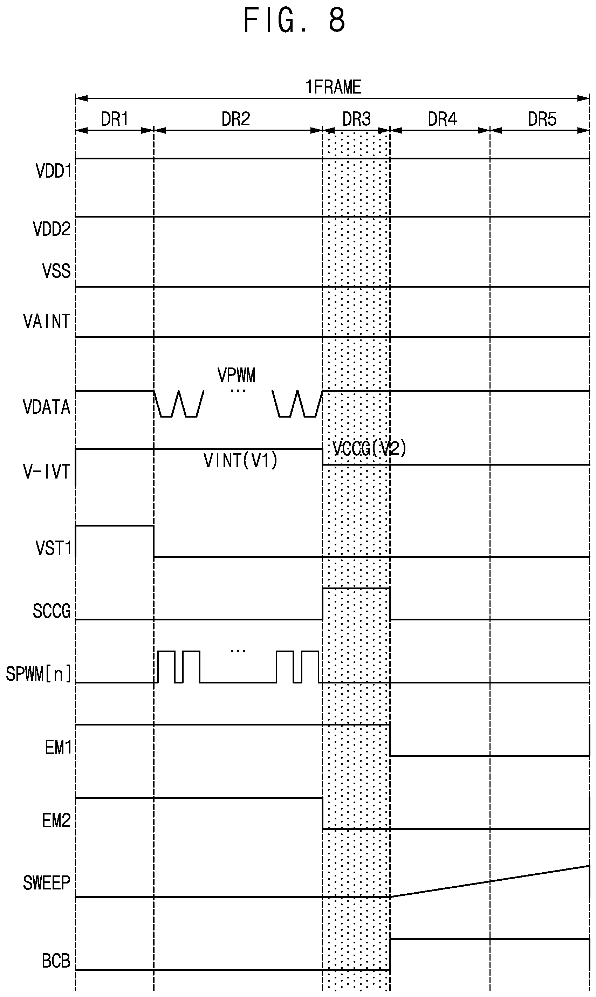

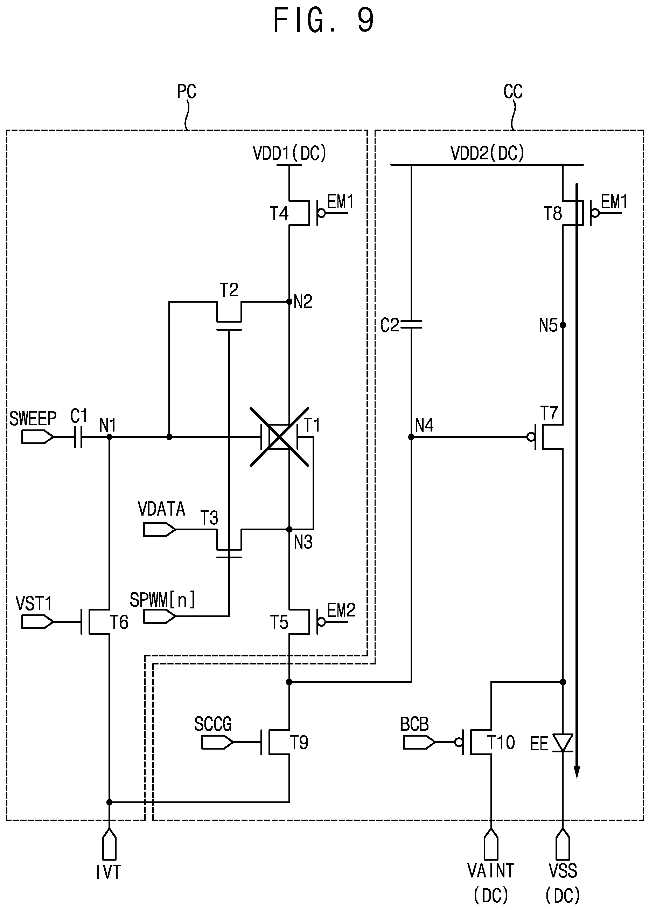

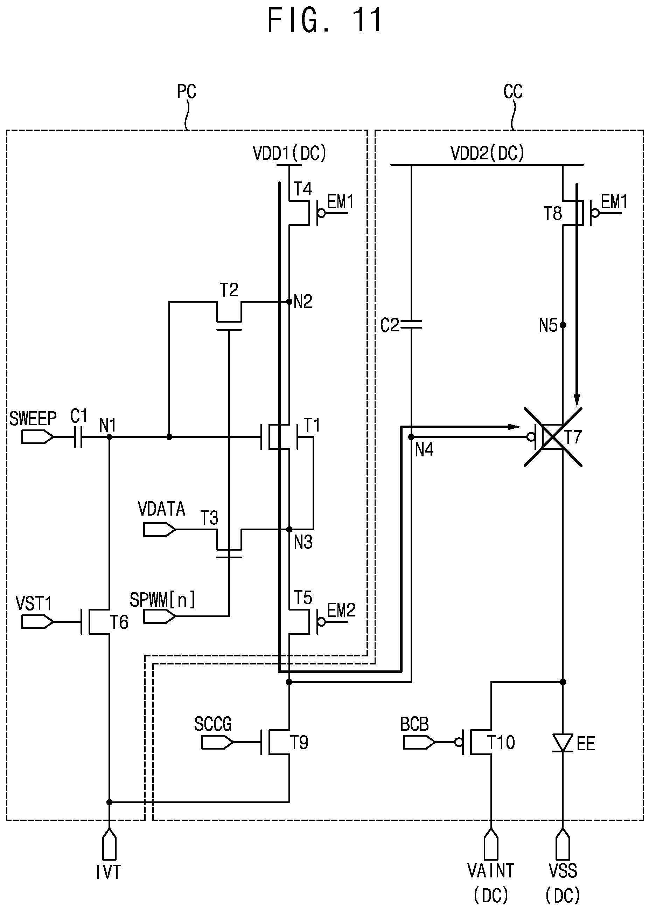

FIG. 3 is a circuit diagram illustrating an operation of the pixel circuit of FIG. 2 in a first period DR1 of a driving timing. FIG. 4 is a timing diagram illustrating an example of input signals applied to the pixel circuit of FIG. 2 and node signals of the pixel circuit of FIG. 2 in the first period DR1. FIG. 5 is a circuit diagram illustrating an operation of the pixel circuit of FIG. 2 in a second period DR2 of the driving timing. FIG. 6 is a timing diagram illustrating an example of input signals applied to the pixel circuit of FIG. 2 and node signals of the pixel circuit of FIG. 2 in the second period DR2. FIG. 7 is a circuit diagram illustrating an operation of the pixel circuit of FIG. 2 in a third period DR3 of the driving timing. FIG. 8 is a timing diagram illustrating an example of input signals applied to the pixel circuit of FIG. 2 and node signals of the pixel circuit of FIG. 2 in the third period DR3. FIG. 9 is a circuit diagram illustrating an operation of the pixel circuit of FIG. 2 in a fourth period DR4 of the driving timing. FIG. 10 is a timing diagram illustrating an example of input signals applied to the pixel circuit of FIG. 2 and node signals of the pixel circuit of FIG. 2 in the fourth period DR4. FIG. 11 is a circuit diagram illustrating an operation of the pixel circuit of FIG. 2 in a fifth period DR5 of the driving timing. FIG. 12 is a timing diagram illustrating an example of input signals applied to the pixel circuit of FIG. 2 and node signals of the pixel circuit of FIG. 2 in the fifth period DR5.

In the driving timing, the first period DR1 may be an "initialization period", the second period DR2 may be a "pulse width modulation data writing and compensation period", the third period DR3 may be a "constant-current voltage writing period", the fourth period DR4 may be the "light emission period" and the fifth period DR5 may be the "light emission off period".

A width of the fourth period DR4 which is the light emission period may be determined by a level of the pulse width modulation data VPWM.

The sweep signal SWEEP may have a constant low level in the first period DR1, the second period DR2 and the third period DR3 and may gradually increase in the fourth period DR4 and the fifth period DR5.

Referring to FIGS. 3 and 4, in the first period DR1, the first initialization signal VST1 may have an active level, the second initialization signal BCB may have an active level, the first scan signal SPWM[n] may have an inactive level, the second scan signal SCCG may have an inactive level, the first emission signal EM1 may have an inactive level, the second emission signal EM2 may have an inactive level, the sweep signal SWEEP may have the low level and the voltage V-IVT outputted from the first initialization voltage terminal IVT may have the first level V1 (the first initialization voltage VINT).

Herein, when the transistor for receiving the first initialization signal VST1, the second initialization signal BCB, the first scan signal SPWM[n], the second scan signal SCCG, the first emission signal EM1 and the second emission signal EM2 is a P-type transistor, the active level may be a low level and the inactive level may be a high level. In contrast, when the transistor for receiving the first initialization signal VST1, the second initialization signal BCB, the first scan signal SPWM[n], the second scan signal SCCG, the first emission signal EM1 and the second emission signal EM2 is an N-type transistor, the active level may be a high level and the inactive level may be a low level.

The first period DR1 may be the initialization period. In the initialization period DR1, the sixth transistor T6 and the tenth transistor T10 may be turned on.

In the initialization period DR1, the control electrode (the first node N1) of the first transistor T1 may be initialized by the first initialization voltage VINT through the sixth transistor T6. The first initialization voltage VINT may be a level to turn on the first transistor T1. In the initialization period DR1, the anode electrode of the light emitting element EE may be initialized by the second initialization voltage VAINT through the tenth transistor T10.

Referring to FIGS. 5 and 6, in the second period DR2 subsequent to the first period DR1, the first initialization signal VST1 may have an inactive level, the second initialization signal BCB may have the active level, the first scan signal SPWM[n] may have an active level, the second scan signal SCCG may have the inactive level, the first emission signal EM1 may have the inactive level, the second emission signal EM2 may have the inactive level and the sweep signal SWEEP may have the low level. When the first scan signal SPWM[n] has an active level, the first scan signal SPWM[n] may have several sequential active pulses during the period (the second period DR2) as shown in FIG. 6 to implement pulse width modulation data writing.

The second period DR2 may be the pulse width modulation data writing and compensation period. In the pulse width modulation data writing and compensation period DR2, the second transistor T2 may be turned on by the first scan signal SPWM[n], the first transistor T1 may be turned on by the first initialization voltage VINT in the initialization period DR1 and the third transistor T3 may be turned on by the first scan signal SPWM[n]. In the pulse width modulation data writing and compensation period DR2, a turned-on state of the tenth transistor T10 may be maintained.

In the pulse width modulation data writing and compensation period DR2, the data voltage VPWM may be applied to the control electrode of the first transistor T1 along a path of the third transistor T3, the first transistor T1 and the second transistor T2. By the second transistor T2 which is diode-connected, a threshold voltage of the first transistor T1 may be compensated in the data voltage VPWM.

Referring to FIGS. 7 and 8, in the third period DR3 subsequent to the second period DR2, the first initialization signal VST1 may have the inactive level, the second initialization signal BCB may have the active level, the first scan signal SPWM[n] may have the inactive level, the second scan signal SCCG may have an active level, the first emission signal EM1 may have the inactive level, the second emission signal EM2 may have an active level, the sweep signal SWEEP may have the low level and the voltage V-IVT outputted from the first initialization voltage terminal IVT may have the second level V2 (VCCG).

The third period DR3 may be the constant-current voltage writing period. In the constant-current voltage writing period DR3, the ninth transistor T9 may be turned on by the second scan signal SCCG and the fifth transistor T5 may be turned on by the second emission signal EM2. In the constant-current voltage writing period DR3, the turned-on state of the tenth transistor T10 may be maintained.

In the constant-current voltage writing period DR3, the constant-current voltage VCCG may be applied to the control electrode of the seventh transistor T7 through the ninth transistor T9. In the constant-current voltage writing period DR3, the constant-current voltage VCCG may be applied to the third node N3 along a path of the ninth transistor T9 and the fifth transistor T5. When the constant-current voltage VCCG is applied to the third node N3, a gate-source voltage Vgs of the first transistor T1 is changed so that the first transistor T1 may be turned off.

Referring to FIGS. 9 and 10, in the fourth period DR4 subsequent to the third period DR3, the first initialization signal VST1 may have the inactive level, the second initialization signal BCB may have an inactive level, the first scan signal SPWM[n] may have the inactive level, the second scan signal SCCG may have the inactive level, the first emission signal EM1 may have an active level, the second emission signal EM2 may have the active level and the sweep signal SWEEP may gradually increase from the low level.

The fourth period DR4 may be the light emission period. In the light emission period DR4, the fourth transistor T4 and the eighth transistor T8 may be turned on by the first emission signal EM1, the seventh transistor T7 may be turned on by the constant-current voltage VCCG and the fifth transistor T5 may be turned on by the second emission signal EM2.

In the light emission period DR4, a current may flow along a path of the eighth transistor T8, the seventh transistor T7 and the light emitting element EE so that the light emitting element EE may emit a light.

Referring to FIGS. 11 and 12, in the fifth period DR5 subsequent to the fourth period DR4, the first initialization signal VST1 may have the inactive level, the second initialization signal BCB may have the inactive level, the first scan signal SPWM[n] may have the inactive level, the second scan signal SCCG may have the inactive level, the first emission signal EM1 may have the active level, the second emission signal EM2 may have the active level, the sweep signal SWEEP may gradually increase following the fourth period DR4.

The fifth period DR5 may be the light emission off period. As the sweep signal SWEEP increases, the first transistor T1 may be turned on at a certain time point. The certain time point when the first transistor T1 is turned on may be determined by the data voltage VPWM applied to the control electrode of the first transistor T1.

When the first transistor T1 is turned on, the first power voltage VDD1 is applied to the control electrode of the seventh transistor T7 along a path of the fourth transistor T4, the first transistor T1 and the fifth transistor T5.

When the first power voltage VDD1 is applied to the control electrode of the seventh transistor T7, the seventh transistor T7 may be turned off and the light emitting element EE may stop emitting a light.

According to the present embodiment, the pixel circuit may include ten transistors and two capacitors. The pixel circuit may be driven in the pulse width modulation method, operate the internal compensation of the threshold voltage and include the relatively fewer transistors compared to the conventional pixel circuit, so that the high integration may be achieved. Thus, the pixel circuit may be applicable to an ultra-high resolution display apparatus.

In addition, the driving transistor T1 of the pulse width modulation circuit PC is an N-type transistor so that an afterimage characteristic, a response time characteristic when changing from a black image to a white image and a luminance changing rate characteristic according to a temperature may be enhanced.

In addition, the driving transistor T7 of the constant current generating circuit CC is a P-type transistor so that a mobility may be enhanced.

In addition, the second initialization voltage VAINT applied to the second electrode of the tenth transistor T10 is less than the third power voltage VSS applied to the cathode electrode of the light emitting element EE so that a black characteristic of the pixel circuit may be enhanced.

In addition, the first initialization voltage VINT applied to the control electrode of the first transistor T1 and the constant-current voltage VCCG applied to the control electrode of the seventh transistor T7 are outputted from the same voltage terminal so that a number of transistors and a number of signal lines may be reduced.

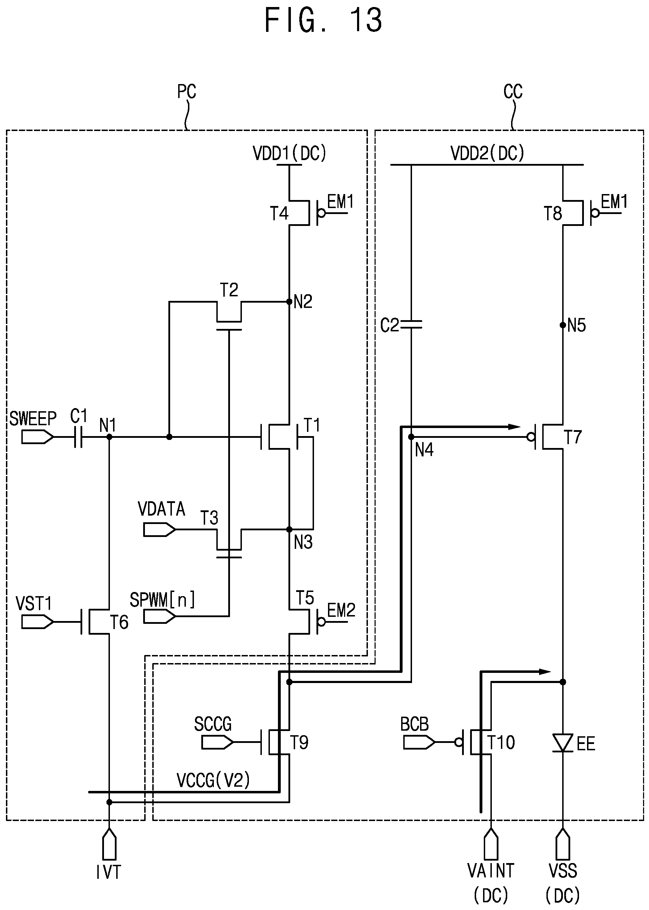

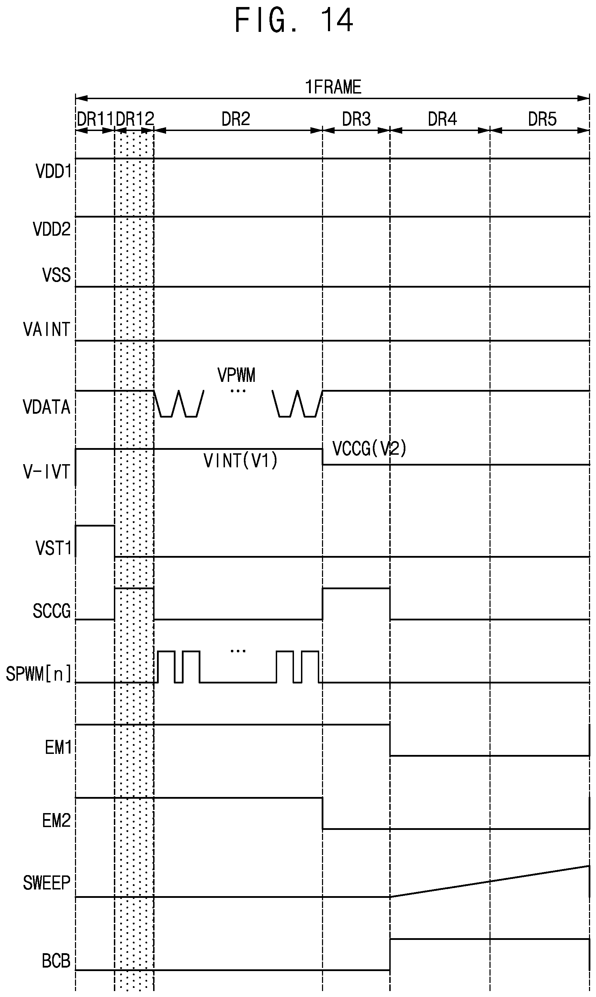

FIG. 13 is a circuit diagram illustrating an operation of the pixel circuit of FIG. 2 in a second initialization period DR12 of the driving timing. FIG. 14 is a timing diagram illustrating an example of input signals applied to the pixel circuit of FIG. 2 and node signals of the pixel circuit of FIG. 2 in the second initialization period DR12.

The driving timing of the pixel circuit according to the present embodiment is substantially the same as the driving timing of the previous embodiment explained referring to FIGS. 4, 6, 8, 10 and 12 except that the driving timing of the pixel circuit further includes a second initialization period. Thus, the same reference numerals will be used to refer to the same or like parts as those described in the previous embodiment and any repetitive explanation concerning the above elements will be omitted.

Referring to FIGS. 1, 2, 13 and 14, in the driving timing, a 1-1 period DR11 may be a "first initialization period", a 1-2 period DR12 may be a "second initialization period", a second period DR2 may be a "pulse width modulation data writing and compensation period", a third period DR3 may be a "constant-current voltage writing period", a fourth period DR4 may be a "light emission period" and a fifth period DR5 may be a "light emission off period".

In the first initialization period DR11, the first initialization signal VST1 may have an active level, the second initialization signal BCB may have an active level, the first scan signal SPWM[n] may have an inactive level, the second scan signal SCCG may have an inactive level, the first emission signal EM1 may have an inactive level, the second emission signal EM2 may have an inactive level, the sweep signal SWEEP may have the low level and the voltage V-IVT outputted from the first initialization voltage terminal IVT may have the first level V1 (the first initialization voltage VINT).

In the first initialization period DR11, the sixth transistor T6 and the tenth transistor T10 may be turned on.

In the first initialization period DR11, the control electrode (the first node N1) of the first transistor T1 may be initialized by the first initialization voltage VINT through the sixth transistor T6. The first initialization voltage VINT may be a level to turn on the first transistor T1. In the first initialization period DR11, the anode electrode of the light emitting element EE may be initialized by the second initialization voltage VAINT through the tenth transistor T10.

In the second initialization period DR12 subsequent to the first initialization period DR11, the first initialization signal VST1 may have an inactive level, the second initialization signal BCB may have the active level, the first scan signal SPWM[n] may have the inactive level, the second scan signal SCCG may have an active level, the first emission signal EM1 may have the inactive level, the second emission signal EM2 may have the inactive level, the sweep signal SWEEP may have the low level and the voltage V-IVT outputted from the first initialization voltage terminal IVT may have the first level V1.

In the second initialization period DR12, the ninth transistor T9 may be turned on. The control electrode (the fourth node N4) of the seventh transistor T7 may be initialized by the first initialization voltage VINT through the ninth transistor T9. The first initialization voltage VINT may be a level to turn off the seventh transistor T7. In the second initialization period DR12, the anode electrode of the light emitting element EE may be initialized by the second initialization voltage VAINT through the tenth transistor T10.

According to the present embodiment, the pixel circuit may include ten transistors and two capacitors. The pixel circuit may be driven in the pulse width modulation method, operate the internal compensation of the threshold voltage and include the relatively fewer transistors compared to the conventional pixel circuit, so that the high integration may be achieved. Thus, the pixel circuit may be applicable to an ultra-high resolution display apparatus.

In addition, the driving transistor T1 of the pulse width modulation circuit PC is an N-type transistor so that an afterimage characteristic, a response time characteristic when changing from a black image to a white image and a luminance changing rate characteristic according to a temperature may be enhanced.

In addition, the driving transistor T7 of the constant current generating circuit CC is a P-type transistor so that a mobility may be enhanced.

In addition, the second initialization voltage VAINT applied to the second electrode of the tenth transistor T10 is less than the third power voltage VSS applied to the cathode electrode of the light emitting element EE so that a black characteristic of the pixel circuit may be enhanced.

In addition, the first initialization voltage VINT applied to the control electrode of the first transistor T1 and the constant-current voltage VCCG applied to the control electrode of the seventh transistor T7 are outputted from the same voltage terminal so that a number of transistors and a number of signal lines may be reduced.

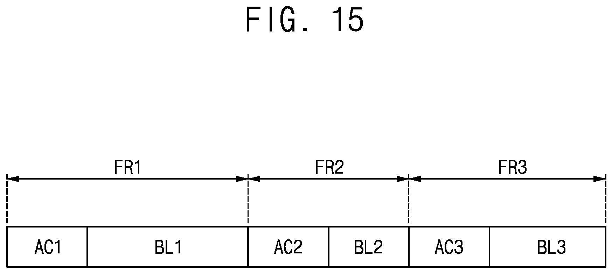

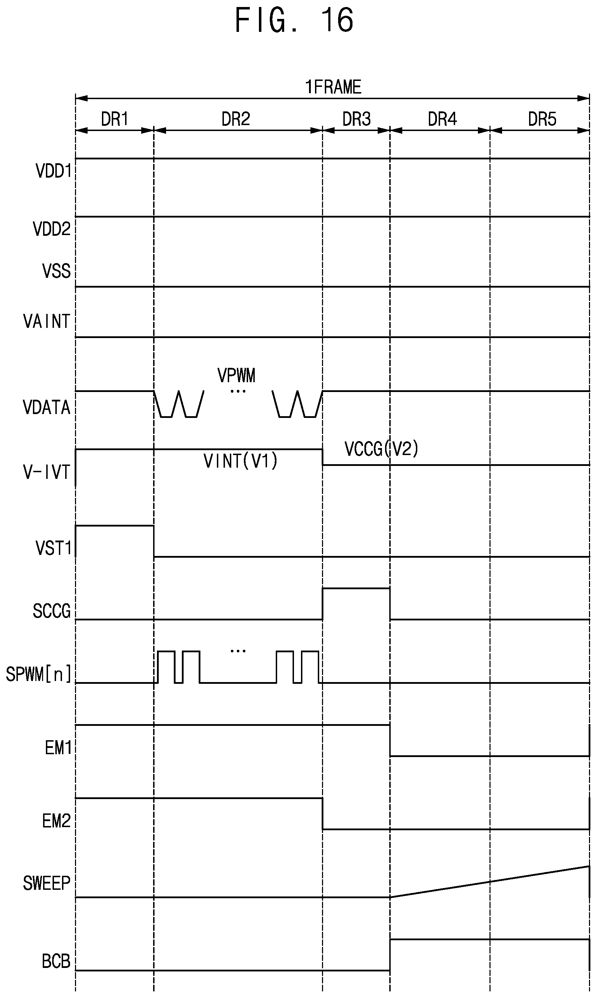

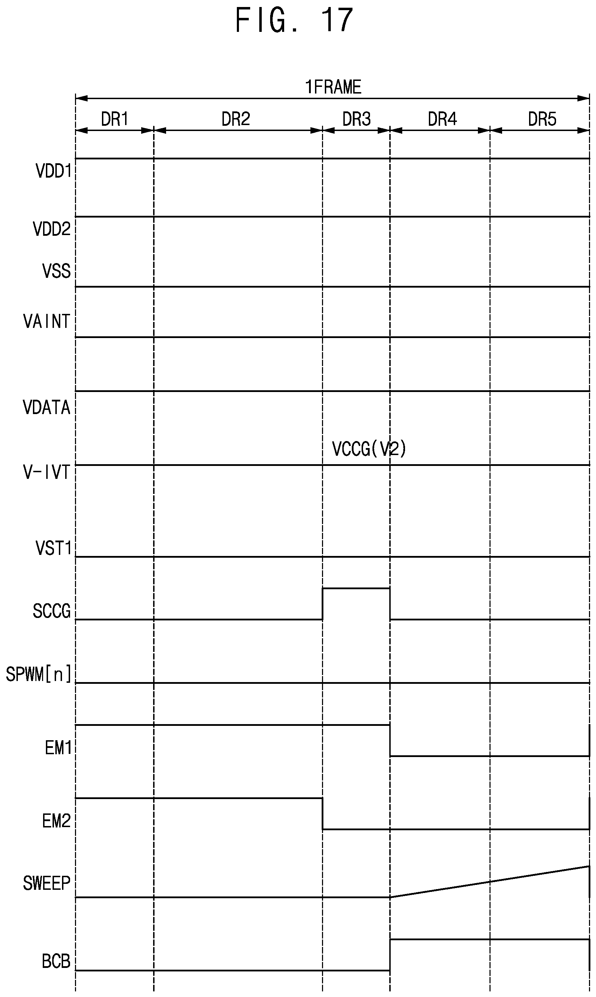

FIG. 15 is a diagram illustrating a driving frequency of the display panel 100 of FIG. 1. FIG. 16 is a timing diagram illustrating an example of input signals applied to the pixel circuit of FIG. 2 and node signals of the pixel circuit of FIG. 2 in a writing frame. FIG. 17 is a timing diagram illustrating an example of input signals applied to the pixel circuit of FIG. 2 and node signals of the pixel circuit of FIG. 2 in a holding frame.

The driving timing of the pixel circuit according to the present embodiment is substantially the same as the driving timing of the previous embodiment explained referring to FIGS. 4, 6, 8, 10 and 12 except that the display panel is driven in a variable frequency. Thus, the same reference numerals will be used to refer to the same or like parts as those described in the previous embodiment and any repetitive explanation concerning the above elements will be omitted.

Referring to FIGS. 1, 2 and 15 to 17, the display panel 100 may be driven in a variable frequency. A first frame FR1 having a first frequency may include a first active period AC1 and a first blank period BL1. A second frame FR2 having a second frequency different from the first frequency may include a second active period AC2 and a second blank period BL2. A third frame FR3 having a third frequency different from the first frequency and the second frequency may include a third active period AC3 and a third blank period BL3.

The first active period AC1 may have a length same as a length of the second active period AC2. The first blank period BL1 may have a length different from a length of the second blank period BL2.

The second active period AC2 may have the length same as a length of the third active period AC3. The second blank period BL2 may have the length different from a length of the third blank period BL3.

The display apparatus supporting the variable frequency may include a writing frame in which the data voltage is written to the pixel and a holding frame in which only light emission is operated without writing the data voltage to the pixel. The writing frame may be in the active period AC1, AC2 and AC3. The holding frame may be in the blank period BL1, BL2 and BL3.

For example, in the writing frame, the data voltage VPWM may be applied to the first transistor T1 and the light emitting element EE may emit a light. For example, in the holding frame, the data voltage VPWM may not be applied to the first transistor T1 and the light emitting element EE may emit a light.

In the driving timing of the writing frame of FIG. 16, the first period DR1 may be an initialization period, the second period DR2 may be a pulse width modulation data writing and compensation period, the third period DR3 may be a constant-current voltage writing period, the fourth period DR4 may be a light emission period and the fifth period DR5 may be a light emission off period. The driving timing of the writing frame of FIG. 16 may be substantially the same as the driving timings of FIGS. 4, 6, 8, 10 and 12.

In the driving timing of the holding frame of FIG. 17, the first period DR1 may be an initialization period, the second period DR2 may be a pulse width modulation data writing and compensation period, the third period DR3 may be a constant-current voltage writing period, the fourth period DR4 may be a light emission period and the fifth period DR5 may be a light emission off period. In the holding frame, the voltage VDATA of a data voltage terminal maintains a constant level, the voltage V-IVT of the first initialization voltage terminal IVT may maintain the second level V2 (VCCG) and the first initialization signal VST1 may maintain an inactive level and the first scan signal SPWM[n] may maintain an inactive level.

In the first period (DR1 of FIG. 16) of the writing frame, the first initialization signal VST1 may have an active level. In the second period (DR2 of FIG. 16) of the writing frame, the first scan signal SPWM[n] may have an active pulse (specifically, several sequential active pulses to implement pulse width modulation data writing). In the first period (DR1 of FIG. 17) of the holding frame in which the data voltage VPWM is not applied to the first transistor T1 and the light emitting element EE emits a light, the first initialization signal VST1 may have an inactive level. In the second period (DR2 of FIG. 17) of the holding frame, the first scan signal SPWM[n] may have an inactive level.

According to the present embodiment, the pixel circuit may include ten transistors and two capacitors. The pixel circuit may be driven in the pulse width modulation method, operate the internal compensation of the threshold voltage and include the relatively fewer transistors compared to the conventional pixel circuit, so that the high integration may be achieved. Thus, the pixel circuit may be applicable to an ultra-high resolution display apparatus.

In addition, the driving transistor T1 of the pulse width modulation circuit PC is an N-type transistor so that an afterimage characteristic, a response time characteristic when changing from a black image to a white image and a luminance changing rate characteristic according to a temperature may be enhanced.

In addition, the driving transistor T7 of the constant current generating circuit CC is a P-type transistor so that a mobility may be enhanced.

In addition, the second initialization voltage VAINT applied to the second electrode of the tenth transistor T10 is less than the third power voltage VSS applied to the cathode electrode of the light emitting element EE so that a black characteristic of the pixel circuit may be enhanced.

In addition, the first initialization voltage VINT applied to the control electrode of the first transistor T1 and the constant-current voltage VCCG applied to the control electrode of the seventh transistor T7 are outputted from the same voltage terminal so that a number of transistors and a number of signal lines may be reduced.

In addition, in the present embodiment, the pixel circuit may support a variable frequency driving method so that the power consumption of the display apparatus may be reduced.

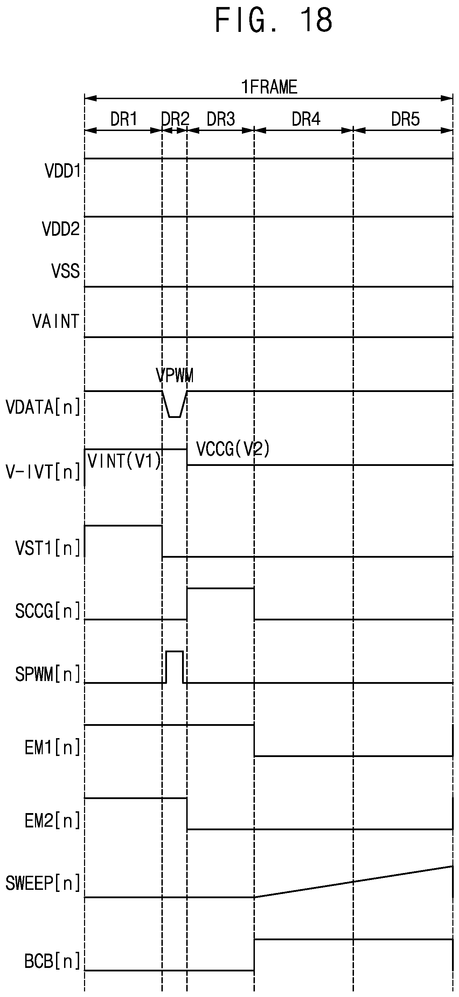

FIG. 18 is a timing diagram illustrating an example of input signals applied to the pixel circuit of FIG. 2 and node signals of the pixel circuit of FIG. 2.

The driving timing of the pixel circuit according to the present embodiment is substantially the same as the driving timing of the previous embodiment explained referring to FIGS. 4, 6, 8, 10 and 12 except that the display panel is driven in a progressive light emission driving method. Thus, the same reference numerals will be used to refer to the same or like parts as those described in the previous embodiment and any repetitive explanation concerning the above elements will be omitted.

Referring to FIGS. 1, 2 and 18, the display panel 100 may be driven in a progressive light emission driving method.

In a driving timing, a first period DR1 may be an initialization period, a second period DR2 may be a pulse width modulation data writing and compensation period, a third period DR3 may be a constant-current voltage writing period, a fourth period DR4 may be a light emission period and a fifth period DR5 may be a light emission off period.

In the present embodiment, the first initialization signal VST1[n], the second initialization signal BCB[n], the first scan signal SPWM[n], the second scan signal SCCG[n], the first emission signal EM1[n], the second emission signal EM2[n] and the sweep signal SWEEP[n] may be progressive scan signals having different timings for pixel rows. Herein, [n] may represent an n-th pixel row.

The first initialization signal VST1[n], the second initialization signal BCB[n], the first scan signal SPWM[n], the second scan signal SCCG[n], the first emission signal EM1[n], the second emission signal EM2[n] and the sweep signal SWEEP[n] may be sequentially applied to the pixel rows.

In addition, the voltage VDATA[n] of the data voltage terminal and the voltage V-IVT[n] of the first initialization voltage terminal IVT may be sequentially applied to the pixel rows.

According to the present embodiment, the pixel circuit may include ten transistors and two capacitors. The pixel circuit may be driven in the pulse width modulation method, operate the internal compensation of the threshold voltage and include the relatively fewer transistors compared to the conventional pixel circuit, so that the high integration may be achieved. Thus, the pixel circuit may be applicable to an ultra-high resolution display apparatus.

In addition, the driving transistor T1 of the pulse width modulation circuit PC is an N-type transistor so that an afterimage characteristic, a response time characteristic when changing from a black image to a white image and a luminance changing rate characteristic according to a temperature may be enhanced.

In addition, the driving transistor T7 of the constant current generating circuit CC is a P-type transistor so that a mobility may be enhanced.

In addition, the second initialization voltage VAINT applied to the second electrode of the tenth transistor T10 is less than the third power voltage VSS applied to the cathode electrode of the light emitting element EE so that a black characteristic of the pixel circuit may be enhanced.

In addition, the first initialization voltage VINT applied to the control electrode of the first transistor T1 and the constant-current voltage VCCG applied to the control electrode of the seventh transistor T7 are outputted from the same voltage terminal so that a number of transistors and a number of signal lines may be reduced.

In addition, in the present embodiment, the pixel circuit may be driven in the progressive light emission driving method.

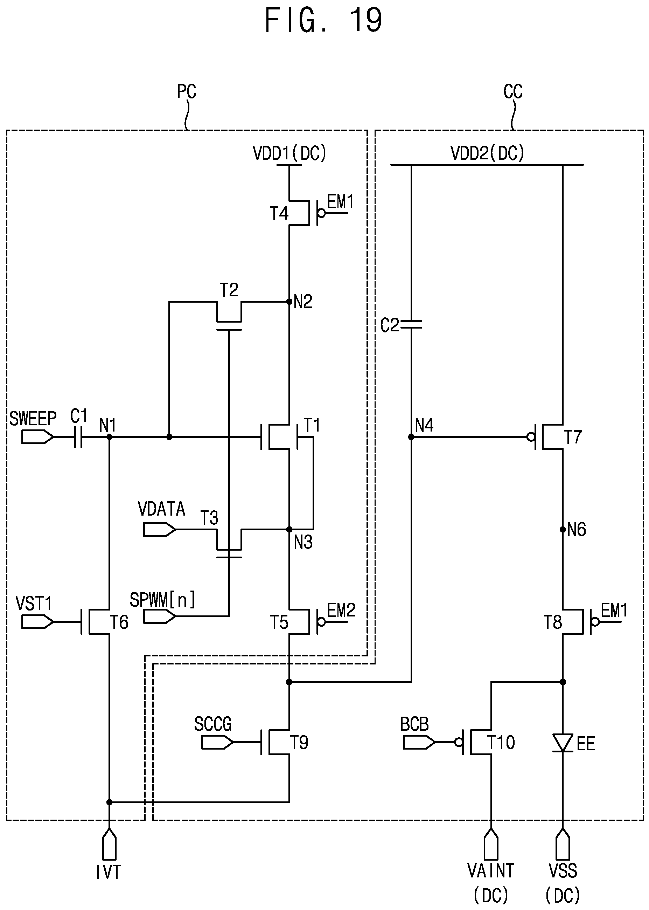

FIG. 19 is a circuit diagram illustrating a pixel circuit of a display panel 100 of a display apparatus according to an embodiment of the present invention.

The pixel circuit according to the present embodiment is substantially the same as the pixel circuit of the previous embodiment explained referring to FIG. 2 except for a position of the eighth transistor T8. Thus, the same reference numerals will be used to refer to the same or like parts as those described in the previous embodiment and any repetitive explanation concerning the above elements will be omitted.

Referring to FIGS. 1, 3 to 12 and 19, the pixel circuit includes the first transistor T1, the second transistor T2, the third transistor T3, the seventh transistor T7, the ninth transistor T9 and the light emitting element EE. The first transistor T1 includes a control electrode connected to a first node N1, a first electrode connected to a second node N2 and a second electrode connected to a third node N3. The second transistor T2 is connected to the first node N1 and the second node N2. The third transistor T3 applies a data voltage (VPWM of FIG. 4) to the first transistor T1. The seventh transistor T7 is connected to a fourth node N4 and applies a driving current to the light emitting element EE. The ninth transistor T9 applies a constant-current voltage (VCCG of FIG. 4) to the fourth node N4. The light emitting element EE emits a light based on the data voltage (VPWM of FIG. 4) and the constant-current voltage (VCCG of FIG. 4).

The first transistor T1 is an N-type transistor. The seventh transistor T7 is a P-type transistor.

The seventh transistor T7 may include a control electrode connected to the fourth node N4, a first electrode for receiving a second power voltage VDD2 and a second electrode connected to a sixth node N6.

The eighth transistor T8 may include a control electrode for receiving the first emission signal EM1, a first electrode connected to the sixth node N6 and a second electrode connected to an anode electrode of the light emitting element EE.

According to the present embodiment, the pixel circuit may include ten transistors and two capacitors. The pixel circuit may be driven in the pulse width modulation method, operate the internal compensation of the threshold voltage and include the relatively fewer transistors compared to the conventional pixel circuit, so that the high integration may be achieved. Thus, the pixel circuit may be applicable to an ultra-high resolution display apparatus.

In addition, the driving transistor T1 of the pulse width modulation circuit PC is an N-type transistor so that an afterimage characteristic, a response time characteristic when changing from a black image to a white image and a luminance changing rate characteristic according to a temperature may be enhanced.

In addition, the driving transistor T7 of the constant current generating circuit CC is a P-type transistor so that a mobility may be enhanced.

In addition, the second initialization voltage VAINT applied to the second electrode of the tenth transistor T10 is less than the third power voltage VSS applied to the cathode electrode of the light emitting element EE so that a black characteristic of the pixel circuit may be enhanced.

In addition, the first initialization voltage VINT applied to the control electrode of the first transistor T1 and the constant-current voltage VCCG applied to the control electrode of the seventh transistor T7 are outputted from the same voltage terminal so that a number of transistors and a number of signal lines may be reduced.

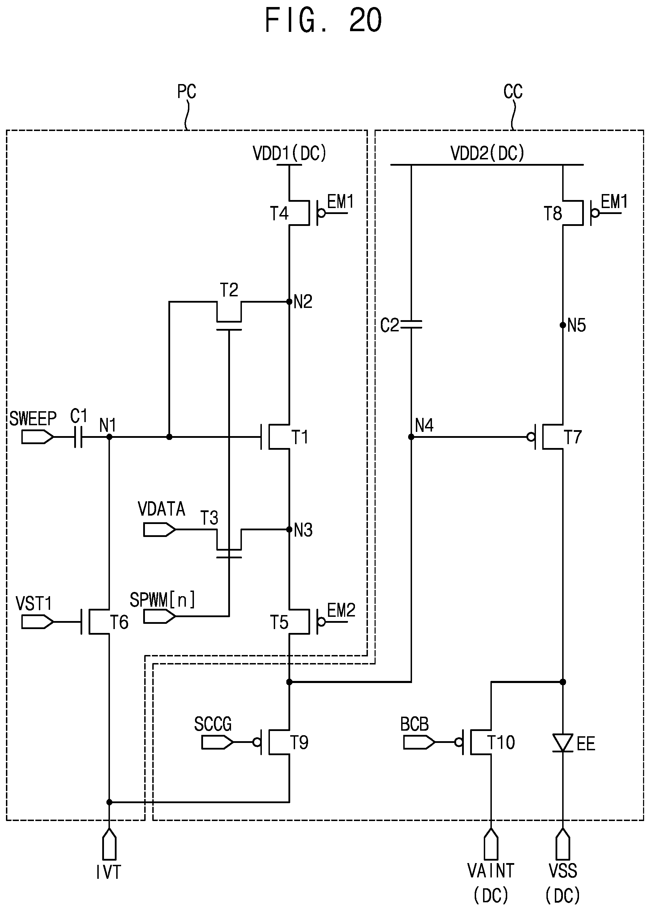

FIG. 20 is a circuit diagram illustrating a pixel circuit of a display panel 100 of a display apparatus according to an embodiment of the present invention.

The pixel circuit according to the present embodiment is substantially the same as the pixel circuit of the previous embodiment explained referring to FIG. 2 except that the first transistor T1 is implemented as a three-terminal transistor. Thus, the same reference numerals will be used to refer to the same or like parts as those described in the previous embodiment and any repetitive explanation concerning the above elements will be omitted.

Referring to FIGS. 1, 3 to 12 and 20, the pixel circuit includes the first transistor T1, the second transistor T2, the third transistor T3, the seventh transistor T7, the ninth transistor T9 and the light emitting element EE. The first transistor T1 includes a control electrode connected to a first node N1, a first electrode connected to a second node N2 and a second electrode connected to a third node N3. The second transistor T2 is connected to the first node N1 and the second node N2. The third transistor T3 applies a data voltage (VPWM of FIG. 4) to the first transistor T1. The seventh transistor T7 is connected to a fourth node N4 and applies a driving current to the light emitting element EE. The ninth transistor T9 applies a constant-current voltage (VCCG of FIG. 4) to the fourth node N4. The light emitting element EE emits a light based on the data voltage (VPWM of FIG. 4) and the constant-current voltage (VCCG of FIG. 4).

The first transistor T1 is an N-type transistor. The seventh transistor T7 is a P-type transistor.

In the present embodiment, the first transistor T1 may not include a second control electrode.

According to the present embodiment, the pixel circuit may include ten transistors and two capacitors. The pixel circuit may be driven in the pulse width modulation method, operate the internal compensation of the threshold voltage and include the relatively fewer transistors compared to the conventional pixel circuit, so that the high integration may be achieved. Thus, the pixel circuit may be applicable to an ultra-high resolution display apparatus.

In addition, the driving transistor T1 of the pulse width modulation circuit PC is an N-type transistor so that an afterimage characteristic, a response time characteristic when changing from a black image to a white image and a luminance changing rate characteristic according to a temperature may be enhanced.

In addition, the driving transistor T7 of the constant current generating circuit CC is a P-type transistor so that a mobility may be enhanced.

In addition, the second initialization voltage VAINT applied to the second electrode of the tenth transistor T10 is less than the third power voltage VSS applied to the cathode electrode of the light emitting element EE so that advantageously a black characteristic of the pixel circuit may be enhanced.

In addition, the first initialization voltage VINT applied to the control electrode of the first transistor T1 and the constant-current voltage VCCG applied to the control electrode of the seventh transistor T7 are outputted from the same voltage terminal so that a number of transistors and a number of signal lines may be reduced.

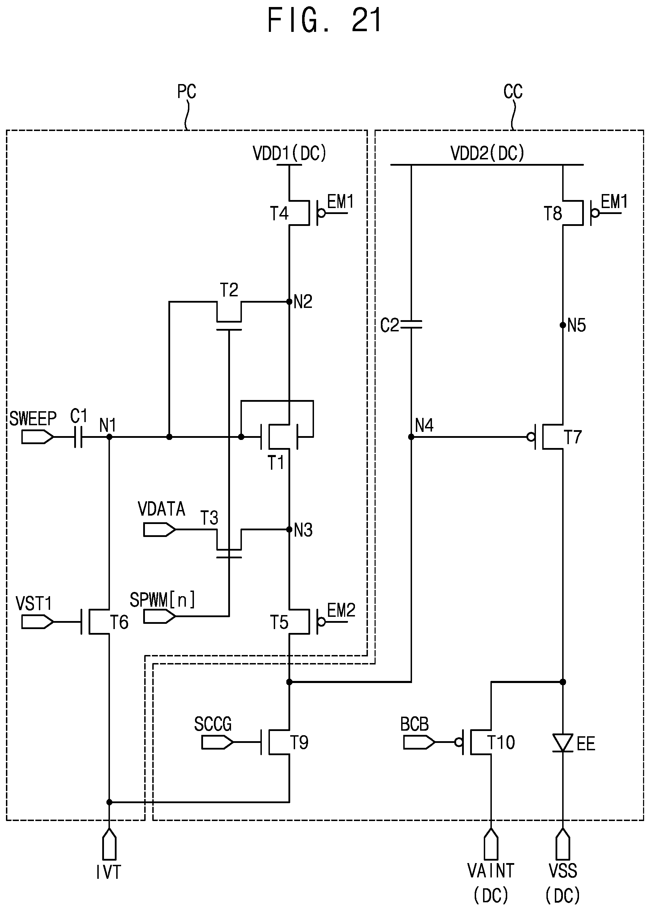

FIG. 21 is a circuit diagram illustrating a pixel circuit of a display panel 100 of a display apparatus according to an embodiment of the present invention.

The pixel circuit according to the present embodiment is substantially the same as the pixel circuit of the previous embodiment explained referring to FIG. 2 except that the second control electrode of the first transistor T1 is connected to the control electrode of the first transistor T1. Thus, the same reference numerals will be used to refer to the same or like parts as those described in the previous embodiment and any repetitive explanation concerning the above elements will be omitted.

Referring to FIGS. 1, 3 to 12 and 21, the pixel circuit includes the first transistor T1, the second transistor T2, the third transistor T3, the seventh transistor T7, the ninth transistor T9 and the light emitting element EE. The first transistor T1 includes a control electrode connected to a first node N1, a first electrode connected to a second node N2 and a second electrode connected to a third node N3. The second transistor T2 is connected to the first node N1 and the second node N2. The third transistor T3 applies a data voltage (VPWM of FIG. 4) to the first transistor T1. The seventh transistor T7 is connected to a fourth node N4 and applies a driving current to the light emitting element EE. The ninth transistor T9 applies a constant-current voltage (VCCG of FIG. 4) to the fourth node N4. The light emitting element EE emits a light based on the data voltage (VPWM of FIG. 4) and the constant-current voltage (VCCG of FIG. 4).

The first transistor T1 is an N-type transistor. The seventh transistor T7 is a P-type transistor.

In the present embodiment, the first transistor T1 may further include a second control electrode connected to the first node N1. When the second control electrode of the first transistor T1 is connected to the first node N1, an operation speed of the first transistor T1 may be enhanced.

According to the present embodiment, the pixel circuit may include ten transistors and two capacitors. The pixel circuit may be driven in the pulse width modulation method, operate the internal compensation of the threshold voltage and include the relatively fewer transistors compared to the conventional pixel circuit, so that the high integration may be achieved. Thus, the pixel circuit may be applicable to an ultra-high resolution display apparatus.

In addition, the driving transistor T1 of the pulse width modulation circuit PC is an N-type transistor so that an afterimage characteristic, a response time characteristic when changing from a black image to a white image and a luminance changing rate characteristic according to a temperature may be enhanced.

In addition, the driving transistor T7 of the constant current generating circuit CC is a P-type transistor so that a mobility may be enhanced.

In addition, the second initialization voltage VAINT applied to the second electrode of the tenth transistor T10 is less than the third power voltage VSS applied to the cathode electrode of the light emitting element EE so that a black characteristic of the pixel circuit may be enhanced.

In addition, the first initialization voltage VINT applied to the control electrode of the first transistor T1 and the constant-current voltage VCCG applied to the control electrode of the seventh transistor T7 are outputted from the same voltage terminal so that a number of transistors and a number of signal lines may be reduced.

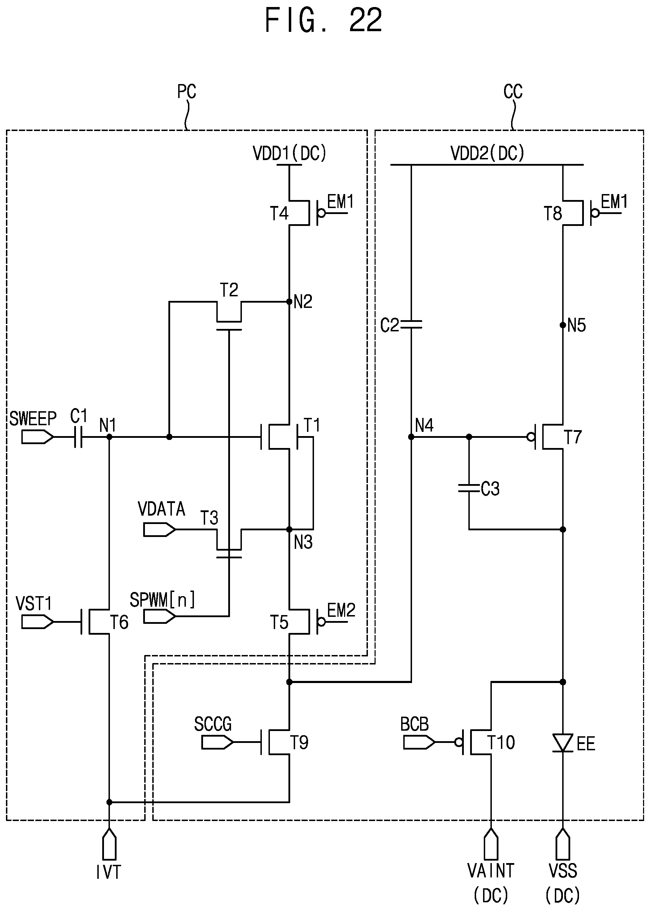

FIG. 22 is a circuit diagram illustrating a pixel circuit of a display panel 100 of a display apparatus according to an embodiment of the present invention.

The pixel circuit according to the present embodiment is substantially the same as the pixel circuit of the previous embodiment explained referring to FIG. 2 except that the pixel circuit further includes a third capacitor. Thus, the same reference numerals will be used to refer to the same or like parts as those described in the previous embodiment and any repetitive explanation concerning the above elements will be omitted.

Referring to FIGS. 1, 3 to 12 and 22, the pixel circuit includes the first transistor T1, the second transistor T2, the third transistor T3, the seventh transistor T7, the ninth transistor T9 and the light emitting element EE. The first transistor T1 includes a control electrode connected to a first node N1, a first electrode connected to a second node N2 and a second electrode connected to a third node N3. The second transistor T2 is connected to the first node N1 and the second node N2. The third transistor T3 applies a data voltage (VPWM of FIG. 4) to the first transistor T1. The seventh transistor T7 is connected to a fourth node N4 and applies a driving current to the light emitting element EE. The ninth transistor T9 applies a constant-current voltage (VCCG of FIG. 4) to the fourth node N4. The light emitting element EE emits a light based on the data voltage (VPWM of FIG. 4) and the constant-current voltage (VCCG of FIG. 4).

The first transistor T1 is an N-type transistor. The seventh transistor T7 is a P-type transistor.

The seventh transistor T7 may include a control electrode connected to the fourth node N4, a first electrode connected to a fifth node N5 and a second electrode connected to an anode electrode of the light emitting element EE.

The eighth transistor T8 may include a control electrode for receiving the first emission signal EM1, a first electrode for receiving a second power voltage VDD2 and a second electrode connected to the fifth node N5.

In the present embodiment, the pixel circuit may further include a third capacitor C3 including a first electrode connected to the control electrode of the seventh transistor T7 and a second electrode connected to the second electrode of the seventh transistor T7. The first electrode of the third capacitor C3 may be connected to the fourth node N4 and the second electrode of the third capacitor C3 may be connected to the anode electrode of the light emitting element EE. The pixel circuit further includes the third capacitor C3 so that a stain due to voltage differences of the seventh transistors T7 may be compensated.

According to the present embodiment, the pixel circuit may include ten transistors and two capacitors. The pixel circuit may be driven in the pulse width modulation method, operate the internal compensation of the threshold voltage and include the relatively fewer transistors compared to the conventional pixel circuit, so that the high integration may be achieved. Thus, the pixel circuit may be applicable to an ultra-high resolution display apparatus.

In addition, the driving transistor T1 of the pulse width modulation circuit PC is an N-type transistor so that an afterimage characteristic, a response time characteristic when changing from a black image to a white image and a luminance changing rate characteristic according to a temperature may be enhanced.

In addition, the driving transistor T7 of the constant current generating circuit CC is a P-type transistor so that a mobility may be enhanced.

In addition, the second initialization voltage VAINT applied to the second electrode of the tenth transistor T10 is less than the third power voltage VSS applied to the cathode electrode of the light emitting element EE so that a black characteristic of the pixel circuit may be enhanced.

In addition, the first initialization voltage VINT applied to the control electrode of the first transistor T1 and the constant-current voltage VCCG applied to the control electrode of the seventh transistor T7 are outputted from the same voltage terminal so that a number of transistors and a number of signal lines may be reduced.

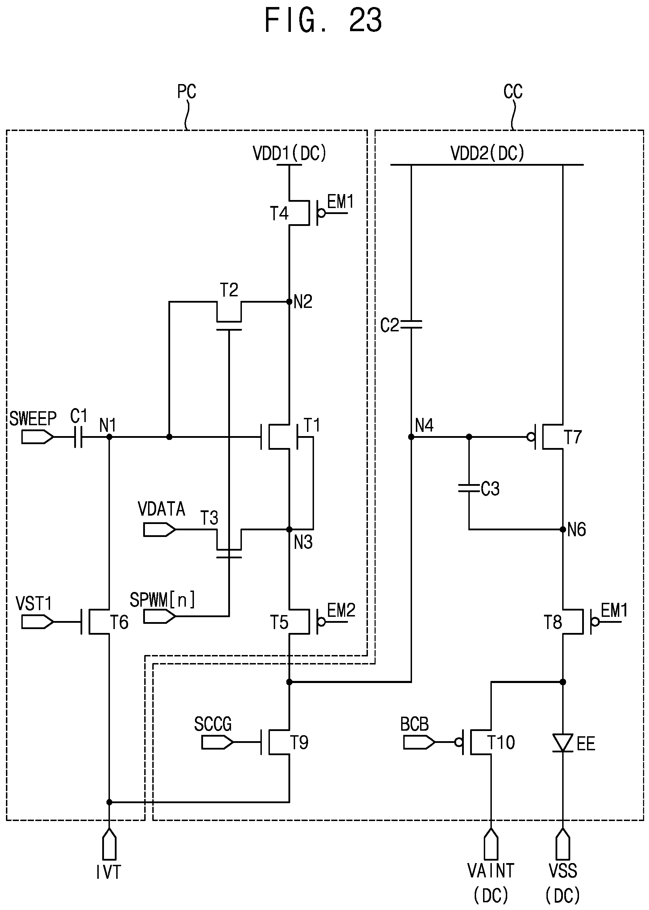

FIG. 23 is a circuit diagram illustrating a pixel circuit of a display panel 100 of a display apparatus according to an embodiment of the present invention.

The pixel circuit according to the present embodiment is substantially the same as the pixel circuit of the previous embodiment explained referring to FIG. 22 except for the position of the eighth transistor. Thus, the same reference numerals will be used to refer to the same or like parts as those described in the previous embodiment and any repetitive explanation concerning the above elements will be omitted.

Referring to FIGS. 1, 3 to 12 and 23, the pixel circuit includes the first transistor T1, the second transistor T2, the third transistor T3, the seventh transistor T7, the ninth transistor T9 and the light emitting element EE. The first transistor T1 includes a control electrode connected to a first node N1, a first electrode connected to a second node N2 and a second electrode connected to a third node N3. The second transistor T2 is connected to the first node N1 and the second node N2. The third transistor T3 applies a data voltage (VPWM of FIG. 4) to the first transistor T1. The seventh transistor T7 is connected to a fourth node N4 and applies a driving current to the light emitting element EE. The ninth transistor T9 applies a constant-current voltage (VCCG of FIG. 4) to the fourth node N4. The light emitting element EE emits a light based on the data voltage (VPWM of FIG. 4) and the constant-current voltage (VCCG of FIG. 4).

The first transistor T1 is an N-type transistor. The seventh transistor T7 is a P-type transistor.

The seventh transistor T7 may include a control electrode connected to the fourth node N4, a first electrode for receiving a second power voltage VDD2 and a second electrode connected to a sixth node N6.

The eighth transistor T8 may include a control electrode for receiving the first emission signal EM1, a first electrode connected to the sixth node N6 and a second electrode connected to an anode electrode of the light emitting element EE.

In the present embodiment, the pixel circuit may further include a third capacitor C3 including a first electrode connected to the control electrode of the seventh transistor T7 and a second electrode connected to the second electrode of the seventh transistor T7. The first electrode of the third capacitor C3 may be connected to the fourth node N4 and the second electrode of the third capacitor C3 may be connected to the sixth node N6. The pixel circuit further includes the third capacitor C3 so that a stain due to voltage differences of the seventh transistors T7 may be compensated.

According to the present embodiment, the pixel circuit may include ten transistors and two capacitors. The pixel circuit may be driven in the pulse width modulation method, operate the internal compensation of the threshold voltage and include the relatively fewer transistors compared to the conventional pixel circuit, so that the high integration may be achieved. Thus, the pixel circuit may be applicable to an ultra-high resolution display apparatus.

In addition, the driving transistor T1 of the pulse width modulation circuit PC is an N-type transistor so that an afterimage characteristic, a response time characteristic when changing from a black image to a white image and a luminance changing rate characteristic according to a temperature may be enhanced.

In addition, the driving transistor T7 of the constant current generating circuit CC is a P-type transistor so that a mobility may be enhanced.

In addition, the second initialization voltage VAINT applied to the second electrode of the tenth transistor T10 is less than the third power voltage VSS applied to the cathode electrode of the light emitting element EE so that a black characteristic of the pixel circuit may be enhanced.

In addition, the first initialization voltage VINT applied to the control electrode of the first transistor T1 and the constant-current voltage VCCG applied to the control electrode of the seventh transistor T7 are outputted from the same voltage terminal so that a number of transistors and a number of signal lines may be reduced.

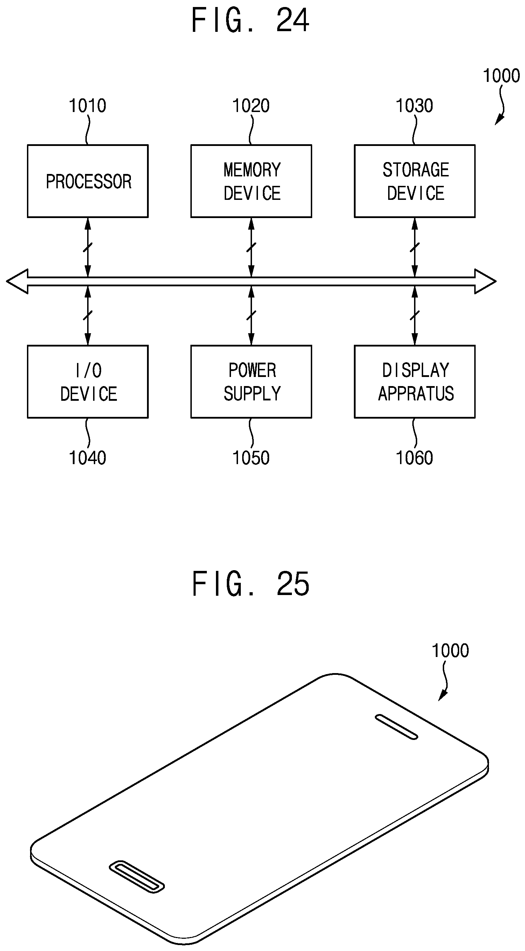

FIG. 24 is a block diagram illustrating an electronic apparatus 1000 according to an embodiment of the present invention. FIG. 25 is a diagram illustrating an example in which the electronic apparatus 1000 of FIG. 24 is implemented as a smart phone.

Referring to FIGS. 24 and 25, the electronic apparatus 1000 may include a processor 1010, a memory device 1020, a storage device 1030, an input/output ("I/O") device 1040, a power supply 1050 and a display apparatus 1060. Here, the display apparatus 1060 may be the display apparatus of FIG. 1. In addition, the electronic apparatus 1000 may further include a plurality of ports for communicating with a video card, a sound card, a memory card, a universal serial bus ("USB") device, other electronic apparatuses, etc.

In an embodiment, as illustrated in FIG. 25, the electronic apparatus 1000 may be implemented as a smart phone. However, the electronic apparatus 1000 is not limited thereto. For example, the electronic apparatus 1000 may be implemented as a cellular phone, a video phone, a smart pad, a smart watch, a tablet PC, a car navigation system, a computer monitor, a laptop, a head mounted display ("HMD") device, and the like.

The processor 1010 may perform various computing functions or various tasks. The processor 1010 may be a micro-processor, a central processing unit ("CPU"), an application processor ("AP"), and the like. The processor 1010 may be coupled to other components via an address bus, a control bus, a data bus, etc. Further, the processor 1010 may be coupled to an extended bus such as a peripheral component interconnection ("PCI") bus.

The processor 1010 may output the input image data IMG and the input control signal CONT to the driving controller 200 of FIG. 1.

The memory device 1020 may store data for operations of the electronic apparatus 1000. For example, the memory device 1020 may include at least one non-volatile memory device such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM") device, a ferroelectric random access memory ("FRAM") device, and the like and/or at least one volatile memory device such as a dynamic random access memory ("DRAM") device, a static random access memory ("SRAM") device, a mobile DRAM device, and the like.

The storage device 1030 may include a solid state drive ("SSD") device, a hard disk drive ("HDD") device, a CD-ROM device, and the like. The I/O device 1040 may include an input device such as a keyboard, a keypad, a mouse device, a touch-pad, a touch-screen, and the like and an output device such as a printer, a speaker, and the like. In some embodiments, the display apparatus 1060 may be included in the I/O device 1040. The power supply 1050 may provide power for operations of the electronic apparatus 1000. The display apparatus 1060 may be coupled to other components via the buses or other communication links.

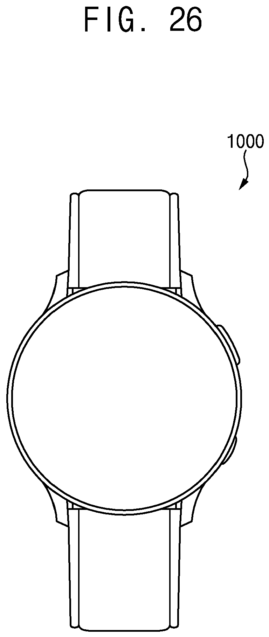

FIG. 26 is a diagram illustrating an example in which the electronic apparatus 1000 of FIG. 24 is implemented as a smart watch.

Referring to FIGS. 24 and 26, the electronic apparatus 1000 may be implemented as a smart watch. The smart watch may be an example of the electronic apparatus 1000 requiring an ultra-high resolution display panel.

According to the pixel circuit and the electronic apparatus of the present invention as explained above, the ultra-high resolution display apparatus may be implemented using the pixel circuit having the high integration.

The foregoing is illustrative of the present invention and is not to be construed as limiting thereof. Although a few embodiments of the present invention have been described, those skilled in the art will readily appreciate that many modifications are possible in the embodiments without materially departing from the novel teachings and advantages of the present invention. Accordingly, all such modifications are intended to be included within the scope of the present invention as defined in the claims. In the claims, means-plus-function clauses are intended to cover the structures described herein as performing the recited function and not only structural equivalents but also equivalent structures. Therefore, it is to be understood that the foregoing is illustrative of the present invention and is not to be construed as limited to the specific embodiments disclosed, and that modifications to the disclosed embodiments, as well as other embodiments, are intended to be included within the scope of the appended claims. The present invention is defined by the following claims, with equivalents of the claims to be included therein.

## Claims

1. A pixel circuit comprising:
a first transistor (T1) including a control electrode connected to a first node (N1), a first electrode connected to a second node (N2) and a second electrode connected to a third node (N3);
a second transistor (T2) connected to the first node (N1) and the second node (N2);
a third transistor (T3) configured to apply a data voltage (VPWM) to the first transistor (T1);
a seventh transistor (T7) connected to a fourth node (N4) and configured to apply a driving current to a light emitting element (EE);
a ninth transistor (T9 configured to apply a constant-current voltage (VCCG) to the fourth node (N4); and
the light emitting element (EE) configured to emit a light based on the data voltage (VPWM) and the constant-current voltage (VCCG),
wherein the first transistor (T1) is an N-type transistor, and
wherein the seventh transistor (T7) is a P-type transistor.

2. The pixel circuit of claim 1, wherein the second transistor (T2), the third transistor (T3) and the ninth transistor (N9) are N-type transistors.

3. The pixel circuit of claim 1 or 2, further comprising a sixth transistor (T6) including a control electrode configured to receive a first initialization signal (VST1[n]), a first electrode connected to the first node (N1) and a second electrode connected to a first initialization voltage terminal (IVT) and/or further comprising a first capacitor (C1) including a first electrode configured to receive a sweep signal (SWEEP[n]) and a second electrode connected to the first node (N1)..

4. The pixel circuit of claims 1 to 3, further comprising a first initialization voltage (VINT) applied to the control electrode of the first transistor (T1) and the constant-current voltage (VCCG) applied to the control electrode of the seventh transistor (T7) being outputted from the same voltage terminal so that a number of transistors and a number of signal lines are reduced.

5. The pixel circuit of claims 1 to 4, further comprising:
a fourth transistor (T4) including a control electrode configured to receive a first emission signal (EM1), a first electrode configured to receive a first power voltage (VDD1) and a second electrode connected to the second node (N2); and
a fifth transistor (T5) including a control electrode configured to receive a second emission signal (EM2), a first electrode connected to the third node (N3) and a second electrode connected to the fourth node (N4).

6. The pixel circuit of claims 1 to 5, further comprising an eighth transistor (T8) including a control electrode configured to receive a first emission signal (EM1), a first electrode configured to receive a second power voltage (VDD2) and a second electrode connected to a first electrode of the seventh transistor (T7) and/or further comprising an eighth transistor (T8) including a control electrode configured to receive a first emission signal (EM1), a first electrode connected to a second electrode of the seventh transistor (T7) and a second electrode connected to an anode electrode of the light emitting element (EE) and/or further comprising a tenth transistor (T10) including a control electrode configured to receive a second initialization signal (BCB[n]), a first electrode connected to an anode electrode of the light emitting element (EE) and a second electrode configured to receive a second initialization voltage (VAINT).

7. The pixel circuit of claims 1 to 6, further comprising a second capacitor (C2) including a first electrode configured to receive a second power voltage (VDD2) and a second electrode connected to the fourth node (N4).

8. The pixel circuit of claims 1 to 7, wherein when the first transistor (T1) is turned off and the seventh transistor (T7) is turned on in a light emission period, the light emitting element (EE) is configured to emit a light, and
wherein when the first transistor (T1) is turned on in a light emission off period, the seventh transistor (T7) is turned off and the light emitting element (EE) is configured to stop emitting a light.

9. The pixel circuit of claims 1 to 8, further comprising:
a fourth transistor (T4) including a control electrode configured to receive a first emission signal (EM1), a first electrode configured to receive a first power voltage (VDD1) and a second electrode connected to the second node (N2); and
an eighth transistor (T8) including a control electrode configured to receive the first emission signal (EM1), a first electrode configured to receive a second power voltage (VDD2) and a second electrode connected to a first electrode of the seventh transistor (T7),
wherein the first power voltage (VDD1) is greater than the second power voltage (VDD2).

10. The pixel circuit of claims 1 to 9, further comprising a tenth transistor (T10) including a control electrode configured to receive a second initialization signal (BCB[n]), a first electrode connected to an anode electrode of the light emitting element (EE) and a second electrode configured to receive a second initialization voltage (VAINT),
wherein a third power voltage (VSS) is applied to a cathode electrode of the light emitting element (EE), and
wherein the second initialization voltage (VAINT) is less than the third power voltage (VSS).

11. The pixel circuit of claims 1 to 10, wherein the first transistor (T1) further includes a second control electrode connected to the third and/or first node (N3, N1).

12. The pixel circuit of claims 1 to 11, wherein the second transistor (T2) includes a control electrode configured to receive a first scan signal (SPWM[n]), a first electrode connected to the first node (N1) and a second electrode connected to the second node (N2),
wherein the third transistor (T3) includes a control electrode configured to receive the first scan signal (SPWM[n]), a first electrode configured to receive the data voltage (VPWM) and a second electrode connected to the third node (N3),
wherein the seventh transistor (T7) includes a control electrode connected to the fourth node (N4), a first electrode connected to a fifth node (N5) and a second electrode connected to an anode electrode of the light emitting element (EE),
wherein the ninth transistor (T9) includes a control electrode configured to receive a second scan signal (SCCG[n]), a first electrode connected to the fourth node (N4) and a second electrode connected to a first initialization voltage terminal (IVT), and
wherein the light emitting element (EE) includes the anode electrode and a cathode electrode configured to receive a third power voltage (VSS).

13. The pixel circuit of claim 12, further comprising:
a fourth transistor (T4) including a control electrode configured to receive a first emission signal (EM1), a first electrode configured to receive a first power voltage (VDD1) and a second electrode connected to the second node (N2);
a fifth transistor (T5) including a control electrode configured to receive a second emission signal (EM2), a first electrode connected to the third node (N3) and a second electrode connected to the fourth node (N4);
a sixth transistor (T6) including a control electrode configured to receive a first initialization signal (VST1[n]), a first electrode connected to the first node (N1) and a second electrode connected to the first initialization voltage terminal (IVT);
an eighth transistor (T8) including a control electrode configured to receive the first emission signal (EM1), a first electrode configured to receive a second power voltage (VDD2) and a second electrode connected to the fifth node (N5);
a tenth transistor (T10) including a control electrode configured to receive a second initialization signal (BCB[n]), a first electrode connected to the anode electrode of the light emitting element (EE) and a second electrode configured to receive a second initialization voltage (VAINT);
a first capacitor (C1) including a first electrode configured to receive a sweep signal (SWEEP[n]) and a second electrode connected to the first node (N1); and
a second capacitor (C2) including a first electrode configured to receive the second power voltage (VDD2) and a second electrode connected to the fourth node (4) and/or wherein the second transistor (T2), the third transistor (T3), the sixth transistor (T6) and the ninth transistor (T9) are N-type transistors, and
wherein the fourth transistor (T4), the fifth transistor (T5), the eighth transistor (T8) and the tenth transistor (T10) are P-type transistors.

14. The pixel circuit of claims 1 to 13, further comprising a third capacitor (C3) including a first electrode connected to an control electrode of the seventh transistor (T7) and a second electrode connected to a second electrode of the seventh transistor (T7).

15. An electronic apparatus (1000) comprising:
a display panel (100) including a pixel circuit;
a gate driver (300) configured to output a gate signal to the pixel circuit; and
a data driver (500) configured to output a data voltage (VPWM) to the pixel circuit,
wherein the pixel circuit comprises:
a first transistor (T1) including a control electrode connected to a first node (N1), a first electrode connected to a second node (N2) and a second electrode connected to a third node (N3);
a second transistor (T2) connected to the first node (N1) and the second node (N2);
a third transistor (T3) configured to apply the data voltage (VPWM) to the first transistor (T1);
a seventh transistor (T7) connected to a fourth node (N4) and configured to apply a driving current to a light emitting element (EE);
a ninth transistor configured to apply a constant-current voltage (VCCG) to the fourth node (N4); and
the light emitting element (EE) configured to emit a light based on the data voltage (VPWM) and the constant-current voltage (VCCG),
wherein the first transistor (T1) is an N-type transistor, and
wherein the seventh transistor (T7) is a P-type transistor.
